(19) **Europäisches Patentamt**
**European Patent Office**
**Office européen des brevets**

(11) **EP 4 559 598 A1**

(12) **EUROPEAN PATENT APPLICATION**

(43) Date of publication:
**28.05.2025 Bulletin 2025/22**

(21) Application number: **24208584.3**

(22) Date of filing: **24.10.2024**

(51) International Patent Classification (IPC):
**B22F 5/04** (2006.01) **B22F 7/06** (2006.01)
**B22F 10/28** (2021.01) **B22F 10/364** (2021.01)
**B22F 10/366** (2021.01) **B22F 10/368** (2021.01)
**B22F 10/38** (2021.01) **B33Y 10/00** (2015.01)
**B33Y 70/00** (2020.01) **B33Y 80/00** (2015.01)
**C22C 1/04** (2023.01) **C22C 19/05** (2006.01)
**C30B 29/52** (2006.01) **B22F 5/00** (2006.01)
**F01D 5/14** (2006.01) **F01D 5/28** (2006.01)
**F23R 3/00** (2006.01) **C30B 28/06** (2006.01)
**C30B 11/00** (2006.01) **C22F 1/10** (2006.01)
**B22F 3/15** (2006.01)

(52) Cooperative Patent Classification (CPC):
(C-Sets available)
**B33Y 80/00; B22F 5/04; B22F 7/06; B22F 10/28;
B22F 10/364; B22F 10/366; B22F 10/368;
B22F 10/38; B33Y 10/00; B33Y 70/00;
C22C 1/0433; C22C 19/056; C30B 11/002;
C30B 11/005; C30B 28/06;** (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.11.2023 US 202318511534**

(71) Applicants:
• **Concept Laser GmbH**
**96215 Lichtenfels (DE)**

• **Arcam AB**
**435 33 Mölnlycke (SE)**

(72) Inventors:
• **Eichler, Simon**
**96215 Lichtenfels (DE)**
• **Ramsperger, Markus**
**435 33 Mölnlycke (SE)**

(74) Representative: **Hafner & Kohl PartmbB
Schleiermacherstraße 25
90491 Nürnberg (DE)**

(54) **ADDITIVELY MANUFACTURED ARTICLES HAVING A MICROSTRUCTURE WITH A HIGH GAMMA-PRIME VOLUME FRACTION**

(57)    An additively manufactured article (200) comprises a superalloy composition and a graded microstructure. The graded microstructure comprises a gamma-prime phase greater than or equal to 35% by volume of the graded microstructure. The graded microstructure comprises: a first section (202) comprising first grains with a first average aspect ratio of greater than or equal to 5 and a second section (204) comprising second grains with a second average aspect ratio of less than 5.

FIG. 1

(Cont. next page)

(52) Cooperative Patent Classification (CPC): (Cont.)
**C30B 29/52; F23R 3/002;** B22F 3/15; B22F 5/009;
B22F 10/64; B22F 12/41; B33Y 40/20; C22F 1/10;
F01D 5/147; F01D 5/28; F05D 2230/22;
F05D 2230/233; F05D 2230/234; F05D 2230/30;
F05D 2230/312; F05D 2240/11; F05D 2240/12;
F05D 2240/15; F05D 2240/30; F05D 2240/35;
F05D 2300/175; F05D 2300/605; F05D 2300/606;
F05D 2300/607; F05D 2300/608; F05D 2300/609;
F23R 2900/00005; F23R 2900/00018

C-Sets
B22F 2999/00, B22F 5/04, B22F 2207/11,
C22C 2200/00;
B22F 2999/00, B22F 7/06, B22F 2207/11;
B22F 2999/00, B22F 7/06, C22C 2200/00

**Description**

*Field*

The present disclosure generally relates to additively manufactured articles and, more particularly, to additively manufactured superalloys having a microstructure with a high gamma-prime volume fraction.

*Technical Background*

Additive manufacturing processes have become more common in recent years for producing superalloy components suitable for high-temperature applications, such as, for example, gas turbine engine components of aircraft engines and power generation equipment. Such components can be fabricated using an additive process, where successive layers of powdered metal are melted and solidified, one on top of the other. For example, electron beam melting is an additive manufacturing process that may be used to fabricate precision three-dimensional metal components from a computer model by melting powdered metal with a high-energy beam of electrons. Electron beam melting and other additive manufacturing processes offer unique opportunities to tailor the microstructure of superalloy components according to material requirements for high-temperature applications. However, crack susceptibility issues have hindered the potential for additively manufactured superalloy components produced from "non-weldable" superalloy compositions.

**BRIEF DESCRIPTION OF THE DRAWINGS**

FIG. 1 schematically depicts an exemplary additive manufacturing system for forming an additively manufactured article, according to one or more embodiments shown and described herein;

FIG. 2 shows a cross-sectional view of an exemplary additively manufactured article in the form of a fused multilayer component, according to one or more embodiments shown and described herein;

FIG. 3 shows weldability chart of several superalloys in terms of the Al content and the Ti content of the superalloy composition;

FIG. 4 schematically depicts a cross-sectional side view of an additively manufactured article comprising a graded microstructure, according to one or more embodiments shown and described herein;

FIG. 5 schematically depicts a cross-sectional side view of an additively manufactured article comprising a graded microstructure with a core and an outer shell, according to one or more embodiments shown and described herein;

FIG. 6 schematically depicts a cross-sectional side view of an embodiment of an additively manufactured turbine blade, according to one or more embodiments shown and described herein;

FIG. 7 schematically depicts a cross-sectional side view of another embodiment of an additively manufactured turbine blade, according to one or more embodiments shown and described herein;

FIG. 8 schematically depicts a cross-sectional side view of another embodiment of an additively manufactured turbine blade, according to one or more embodiments shown and described herein;

FIG. 9 schematically depicts a cross-sectional side view of another embodiment of an additively manufactured turbine blade, according to one or more embodiments shown and described herein;

FIG. 10 shows an image taken during an additive manufacturing process of the present disclosure;

FIG. 11 shows additively manufactured articles produced using an additive manufacturing process of the present disclosure;

FIG. 12 shows images of grain microstructures of additively manufactured articles, according to one or more embodiments shown and described herein;

FIG. 13 shows a tailored microstructure for an additively manufactured turbine blade according to one or more embodiments shown and described herein;

FIG. 14 shows a portion of an additively manufactured turbine blade, according to one or more embodiments shown and described herein;

FIG. 15 schematically depicts melt pools shapes and associated microstructures for various melt parameter sets implemented in additive manufacturing processes, according to one or more embodiments shown and described herein; and

FIG. 16 is a chart showing creep-rupture test results for various additively manufactured articles of the present disclosure.

## DETAILED DESCRIPTION

Reference will now be made in detail to embodiments of additively manufactured articles, embodiments of which are illustrated in the accompanying drawings. Whenever possible, the same reference numerals will be used throughout the drawings to refer to the same or like parts.

The present disclosure generally relates to additively manufactured (AM) articles comprising a superalloy composition and a microstructure having a gamma-prime ($\gamma'$) phase occupying greater than or equal to 35% by volume of the microstructure and having grains with an average aspect ratio of greater than or equal to 5. The superalloy composition may be a nickel-based or cobalt-based superalloy composition.

Chemical elements are discussed in the present disclosure using their common chemical abbreviation, such as commonly found on a periodic table of elements. For example, nickel may be represented by its common chemical abbreviation Ni; cobalt may be represented by its common chemical abbreviation Co, and so forth. Unless specified otherwise, all percentages are provided in terms of "weight percent" or "percent by weight."

As used herein, "superalloy" refers to an alloy having improved physical characteristics compared to conventional alloys, such as but not limited to: relatively high mechanical strength, relatively high thermal creep deformation resistance, relatively high corrosion or oxidation resistance, and good surface stability.

Directional terms as used herein - for example up, down, right, left, front, back, top, bottom - are made only with reference to the figures as drawn and the coordinate axis provided therewith and are not intended to imply absolute orientation.

References herein to the positions of elements (e.g., "top," "bottom," "above," "below") are merely used to describe the orientation of various elements in the figures. It should be noted that the orientation of various elements may differ according to other exemplary embodiments, and that such variations are intended to be encompassed by the present disclosure.

As used herein, the singular forms "a," "an," "the," and "said" include plural referents unless the context clearly dictates otherwise. Thus, for example, reference to "a" component includes aspects having two or more such components, unless the context clearly indicates otherwise. The terms "comprising," "including," and "having" are intended to be inclusive and mean that there may be additional elements other than the listed elements.

As utilized herein, the terms "approximately," "about," "substantially," and similar terms are intended to have a broad meaning in harmony with the common and accepted usage by those of ordinary skill in the art to which the subject matter of this disclosure pertains. Indeed, such terms refer to the subsequently listed property or measurement within normal manufacturing tolerances and imperfections in the relevant field. It should be understood by those of skill in the art who review this disclosure that these terms are intended to allow a description of certain features described and claimed without restricting the scope of these features to the precise numerical values or idealized geometric forms provided. Accordingly, these terms should be interpreted as indicating that insubstantial or inconsequential modifications or alterations of the subject matter described and claimed are considered to be within the scope of the disclosure as recited in the appended claims.

As used herein, the terms "additively manufactured" or "additive manufacturing techniques or processes" refer generally to manufacturing processes wherein successive layers of material(s) are provided on each other to "build-up," layer-by-layer, a three-dimensional (3D) component. The successive layers generally fuse together to form a monolithic component which may have a variety of integral sub-components.

Additive manufacturing processes fabricate components using three-dimensional information, for example a three-dimensional computer model, of the component. Accordingly, a three-dimensional computer model of the component may be defined prior to manufacturing. In this regard, a model or prototype of the component may be scanned to determine the three-dimensional information of the component. As another example, a model of the component may be constructed using a suitable computer aided design (CAD) program to define the three-dimensional computer model of the component. Additive manufacturing provides a variety of manufacturing advantages, including ease of manufacturing, reduced cost, greater accuracy, etc.

The computer model may include 3D numeric coordinates of the entire configuration of the component including both external and internal surfaces of the component. For example, the computer model may define the body, the surface, and/or internal passageways such as openings, support structures, etc. In embodiments, the three-dimensional computer model is converted into a plurality of slices or segments, e.g., along a central (e.g., vertical) axis of the component or any other suitable axis. Each slice may define a thin cross section of the component for a predetermined height of the slice. The successive cross-sectional slices together form the 3D component. The component is then "built-up" slice-by-slice, or layer-by-layer, until finished.

In this manner, each layer may be successively formed, e.g., by using laser energy or heat or by sintering or melting metal powder. For example, a particular type of additive manufacturing process may use an energy beam, for example, an electron beam or photonic beam such as a laser beam, to sinter, at least partially melt, or melt a powder material. Any suitable laser and laser parameters may be used, including considerations with respect to power, laser beam spot size, and scanning velocity. Suitable laser powder bed fusion (L-PBF) additive manufacturing techniques in accordance with the present disclosure include, for example, Selective Laser Melting (SLM), Direct Selective Laser Melting (DSLM), Direct Metal Laser Melting (DMLM), Laser Engineered Net Shaping (LENS), and Laser Net Shape Manufacturing (LNSM), Directed Energy Deposition (DED). Suitable additive manufacturing techniques using an electron beam in accordance with the present disclosure include, for example, Electron Beam Melting (EBM), Directed Energy Deposition (DED), and other known processes. The build material may be formed by any suitable powder or material selected for enhanced strength, durability, and useful life, particularly at high temperatures.

In addition, by utilizing energy beam-based additive processes of the present disclosure, the surface finish and features of the articles may vary as needed depending on the application. For example, the surface finish may be adjusted (e.g., made smoother or rougher) by selecting appropriate parameters for the energy beam (e.g., volume energy, beam power, line offset, beam velocity, focal spot size, focus offset, layer thickness, point distance, point exposure time, point order, etc.) during the additive process, especially in the periphery of a cross-sectional layer which corresponds to the part surface. For example, a rougher finish may be achieved by increasing beam velocity or increasing the size of the melt pool formed, and a smoother finish may be achieved by decreasing beam velocity or decreasing the size of the melt pool formed. The scanning pattern and/or beam power can also be adjusted to change the surface finish in a selected area. Moreover, as discussed in more detail below, the grain microstructure of the additively manufactured articles may be tailored as needed such that the material properties of the additively manufactured articles are suited for their intended use for a specific application.

Additionally, by utilizing the additive manufacturing methods of the present disclosure, even multi-part components may be formed as a single piece of continuous metal and may thus include fewer sub-components and/or joints compared to prior designs. The integral formation of these multi-part components through additive manufacturing may advantageously improve the overall assembly process. For example, the integral formation reduces the number of separate parts that must be assembled, thus reducing associated time and overall assembly costs. Additionally, existing issues with, for example, leakage, joint quality between separate parts, and overall performance may advantageously be reduced.

Also, the additive manufacturing methods described herein enable much more complex and intricate shapes and contours of the articles produced therefrom. For example, such articles may include thin additively manufactured layers containing unique fluid passageways and integral mounting features. In addition, as demonstrated by embodiments, additive manufacturing processes may enable the manufacture of a single article having different materials such that different portions of the article may exhibit different performance characteristics. The successive, additive nature of the manufacturing process may enable the construction of these novel features. As a result, the articles described herein may exhibit improved functionality and reliability.

EBM and L-PBF are two well-established powder bed fusion technologies. As both EBM and L-PBF utilize an energized beam for material consolidation, they are closely linked to welding physics including rapid solidification velocities and high temperature gradients. Rapid solidification velocities and high temperature gradients may lead to high levels of residual stress within the AM components and thereby result in AM components suffering from crack susceptibility issues, particularly for superalloys having a high gamma-prime volume fraction, which are often described as being "non-weldable" or "poorly weldable" due to the inability to tolerate rapid solidification and high temperature gradients. However, the gamma-prime phase is the primary strengthening phase in many superalloys, and superalloys having a high gamma-prime volume fraction often show excellent creep and oxidation properties at high temperatures. Therefore, these superalloys are desirable for high-temperature applications such as, for example, components in gas turbine engines. As such, the demand for AM components formed from these materials has created a need to develop EBM and L-PBF processing techniques capable of handling their non-weldable nature.

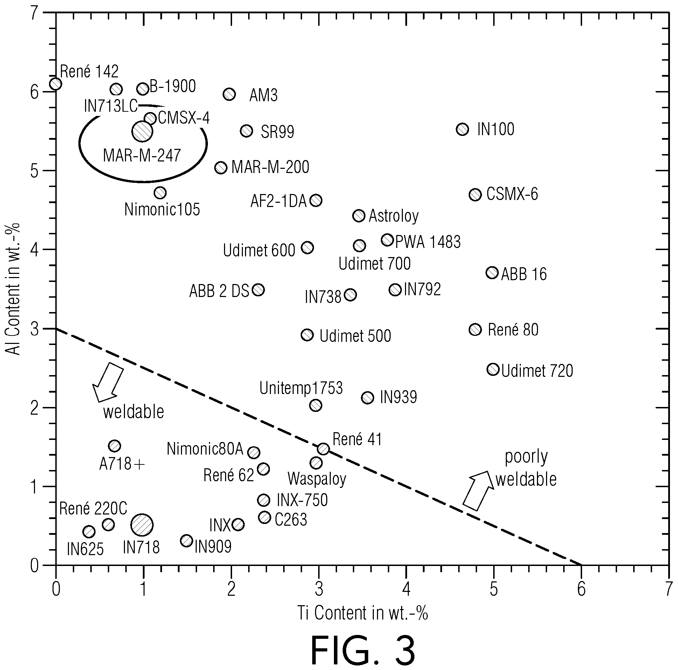

The tendency for superalloys to exhibit a high gamma-prime volume fraction is often correlated with the amount of aluminum and titanium in the superalloy composition, as these elements are gamma-prime forming elements. As such, the combined content of these elements is often looked to as an indicator of the weldability of the superalloy. With reference now to FIG. 3, superalloys exhibiting a high gamma-prime volume fraction are shown above the dotted line corresponding to $w_{Al} + w_{Ti} = 4$ wt.%, where $w_{Al}$ corresponds to a weight percentage of aluminum in the superalloy composition and $w_{Ti}$ corresponds to a weight percentage of titanium in the superalloy composition. Accordingly, superalloys having excellent creep and oxidation properties at high temperatures, but with poor weldability, have a superalloy composition wherein the combination of the Al content and the Ti content is greater than or equal to 4 wt.%. Examples of high gamma-prime superalloys pertinent to the present disclosure include, but are not limited to: Rene 108, Rene N5, Rene N15, RR 1000, GTD 111, GTD 444, MarM 247, CM247LC, and IN 738, some of which are shown in FIG. 3. It should be noted that in addition to the gamma-prime content, weldability is also dependent on the superalloy composition, the grain microstructure, and the grain size distribution. Thus, while the present disclosure is primarily focused on superalloys having a high gamma-prime volume fraction, alloys having a lower gamma-prime volume fraction but nevertheless considered non-weldable due to one or more of these additional factors affecting weldability are also contemplated.

In general, the same crack-susceptibility issues arise from EBM and L-PBF manufacturing of high-gamma prime superalloys. However, EBM processes have proven to be less sensitive to crack formation due to the inherent high build temperatures (> 1000 °C) and isotherm process conditions which may provide an *in-situ* heat treatment to the consolidated material during the additive manufacturing process. These conditions permit EBM methods to achieve fully developed microstructures enclosing gamma-prime and carbide precipitation in the as-built condition, whereas the lower temperatures typical of L-PBF manufacturing can suppress the main gamma-prime precipitation during processing, thus requiring subsequent heat treatments to fully develop the desired extent of gamma-prime precipitation. However, such subsequent heat treatments can trigger strain-age cracking by gamma-prime re-precipitation. Moreover, while platform heating may extend the time for gamma-prime precipitation in L-PBF processes, this approach can only suppress the cooling rate, i.e., extend the time period for main gamma-prime precipitation, in L-PBF melt pools up to a certain distance away from the platform. As the build direction height of the additively manufactured part gets larger, heat from the platform will be less and less able to promote the formation of the gamma-prime phase during the additive manufacturing process. Therefore, the high build temperatures of EBM processes provide an inherent benefit for manufacturing high gamma-prime content superalloys.

Furthermore, flexibility in the e-beam movement and focus allows for advanced beam scan strategies and enables control of the melt pool shape, solidification behavior, and corresponding temperature gradients within the melt pool. Adjustment of these parameters may lead to high solidification velocities that result in homogeneous and fine microstructures up to an order of magnitude smaller than in those achieved in investment casting. Moreover, microstructures resulting from EBM processes disclosed herein may be nearly homogenized in the as-built condition. This results in high-temperature mechanical properties in the as-built EBM condition, equal to or better than as-cast and heat-treated materials. In addition, low-cycle fatigue (LCF) and high-cycle fatigue (HCF) material properties may be improved from smaller EBM pore (defect) sizes in comparison to cast materials.

The present disclosure is directed to additive manufacturing processes that allow the microstructure evolution of the additively manufactured parts to be controlled. In particular, the microstructure evolution may be controlled to produce microstructures representing equiaxed polycrystalline microstructures typical to those produced using conventional casting (CC) but with smaller average grain sizes ("micro casting"), directionally solidified (DS) anisotropic microstructures, and even single-crystal (SX) microstructures, separately or as separate regions within one additively manufactured article. The ability of additive manufacturing processes to form directionally solidified (DS) microstructures is significant because superalloy components exhibiting anisotropic, i.e., columnar grain structures, may have superior time-dependent material properties such as creep strength, thermal fatigue resistance, and corrosion resistance when compared to equiaxed crystal counterparts. In particular uses, DS or SX turbine airfoils have proven to have as much as nine times more relative life in terms of creep strength and thermal fatigue resistance and over three times more relative life for corrosion resistance, when compared to equiaxed crystal counter parts. As such, the additive manufacturing processes of the present disclosure are particularly relevant for the manufacture of turbine airfoils and other components exposed to high temperatures in gas turbine engines. In view of the above, there is an on-going need for EBM and L-PBF processing techniques capable of additively manufacturing non-weldable superalloys having anisotropic microstructures with a high gamma-prime volume fraction.

The present disclosure generally relates to additively manufactured articles produced using advanced beam control strategies that mitigate cracking issues and achieve improved mechanical properties for the additively manufactured articles. A particular focus of the present disclosure is additively manufactured articles having anisotropic microstructures with a high gamma-prime volume fraction. The additively manufactured articles of the present disclosure may possess high-temperature properties equal to or better than articles produced from conventional casting or existing additive manufacturing processes.

The beam scan strategies of the present disclosure enable control of melt pool shape, solidification behavior, and corresponding temperature gradients within the melt pool. The beam scan strategies of the present disclosure may reduce residual stresses and the associated crack susceptibility issues in the resulting additively manufactured articles. Moreover, the beam scan strategies of the present disclosure may allow for control of the grain microstructure evolution in the additively manufactured articles. While the primary focus of the present disclosure relates to articles manufactured with EBM processes, it is contemplated that the beam control strategies disclosed herein may be implemented in L-PBF processes so as to produce the additively manufactured articles disclosed herein.

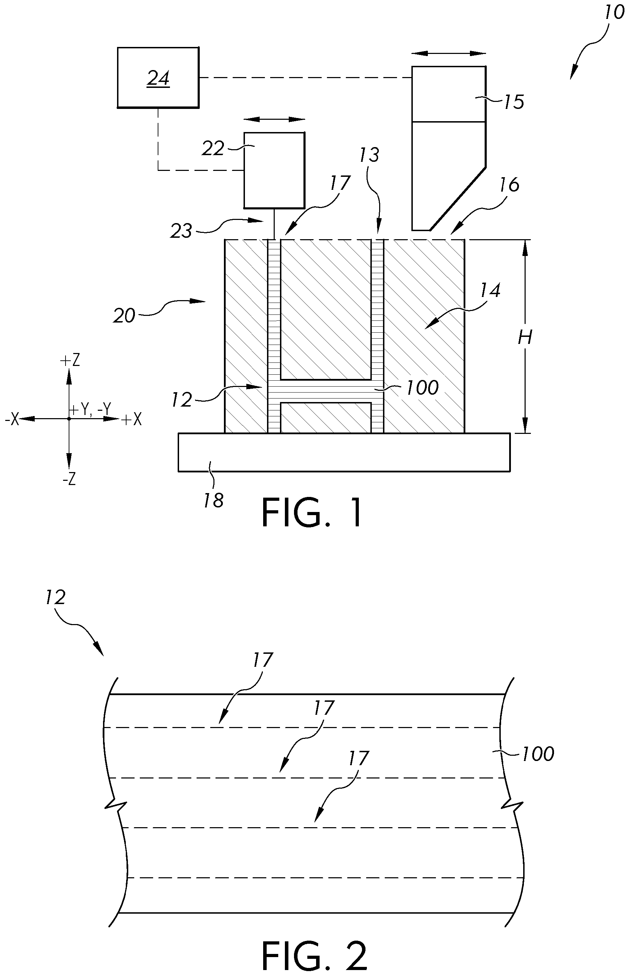

FIG. 1 shows a schematic of an exemplary additive manufacturing system 10 (e.g., an EBM system) for forming an additively manufactured article 12 from a powder 14. For example, a layer 16 of powder 14 (e.g., from powder supply 15) may be applied over the build plate 18 within a build area 20. Then, an energy source 22 may bond a portion 13 of the layer 16 of powder 14 to form a bonded layer portion 17. The energy source 22 may direct energy 23 (e.g., a laser beam) to bond particular portions 13 of the layer 16 of the powder 14. For example, bonding the portion 13 of the layer 16 of the powder 14 may be achieved by directing energy 23 to at least partially melt the portion 13 of the powder 14 to form the bonded layer portion 17. In embodiments, energy 23 is applied according to a CAD model preloaded in a controller 24 that is in communication with the powder supply 15 and the energy source 22. This process can be repeated by forming an additional layer of powder and then bonding a portion of that additional layer of powder until a fused multilayer structure 100 is formed. The additively manufactured article 12 may have a build direction height H, which is the distance between the build plate 18 and the final bonded layer portion 17 when the additive manufacturing process is complete. FIG. 2 shows a fused multilayer structure 100 of additively manufactured article 12 formed from a plurality of bonded layer portions 17.

In embodiments, the additively manufactured articles provided herein may be produced using additive manufacturing processes wherein the energy beam continuously imparts energy to the powder bed as it is traversed across the surface layer of the powder bed. In embodiments, the additively manufactured articles may be produced using additive manufacturing processes that employ adaptive point-based scan strategies as described in United States Patent Application No. 18/228,198, entitled "Generation and Execution of Melting Paths in Additive Manufacturing," filed July 31, 2023, the entire contents of which are incorporated herein by reference. It has been found that maintaining a narrow temperature interval for the melted powder during the additive manufacturing process may be important for producing crack-free additively manufactured articles. As such, the additive manufacturing processes of the present disclosure may combine an intelligent scan pattern with appropriate melt parameters for the energy beam to maintain a narrow temperature interval for the powder during the additive manufacturing process. As described in United States Patent Application No. 18/228,198, the additive manufacturing process may implement a thermal profile, i.e., the temperature (and/or other thermal qualities) of a region of build material (e.g., a portion of a layer or an entire layer) as a function of time, with a margin of error so as to maintain a narrow temperature interval. In embodiments, a thermal profile may comprise a margin of error greater than or equal to $10^{-1}$ K (i.e., Kelvin) and less than or equal to $10^3$ K. In embodiments, a thermal profile may comprise a margin of error of greater than or equal to $10^{-1}$ K, greater than or equal to 1 K, greater than or equal to 10 K, or even greater than or equal to $10^2$ K. In embodiments, a thermal profile may comprise a margin of error of less than or equal to $10^3$ K, less than or equal to $10^2$ K, less than or equal to 10 K, less than or equal to 1 K, or even less than or equal to $10^{-1}$ K. In embodiments, a thermal profile may comprise a margin of error of greater than or equal to $10^{-1}$ K and less than or equal to $10^3$ K. In embodiments, a thermal profile may comprise a margin of error of greater than or equal to $10^{-1}$ K and less than or equal to $10^2$ K. In embodiments, a thermal profile may comprise a margin of error of greater than or equal to $10^{-1}$ K and less than or equal to 10 K. In embodiments, a thermal profile may comprise a margin of error of greater than or equal to $10^{-1}$ K and less than or equal to 1 K. In embodiments, a thermal profile may comprise a margin of error of greater than or equal to 1 K and less than or equal to $10^3$ K. In embodiments, a thermal profile may comprise a margin of error of greater than or equal to 1 K and less than or equal to $10^2$ K. In embodiments, a thermal profile may comprise a margin of error of greater than or equal to 1 K and less than or equal to 10 K. In embodiments, a thermal profile may comprise a margin of error of greater than or equal to 1 K and less than or equal to 1 K. In embodiments, a thermal profile may comprise a margin of error of greater than or equal to 10 K and less than or equal to $10^3$ K. In embodiments, a thermal profile may comprise a margin of error of greater than or equal to 10 K and less than or equal to $10^2$ K. In embodiments, a thermal profile may comprise a margin of error of greater than or equal to $10^2$ K and less than or equal to $10^3$ K.

The beam scan strategies disclosed herein allow for the production of additively manufactured articles having anisotropic microstructures with a high gamma-prime volume fraction. The beam scan strategies of the present disclosure may involve the control of a number of melt parameters that together define the melt pool shape, solidification velocity, temperature gradients, and resulting microstructure of the additively manufactured articles. The beam scan strategies of the present disclosure may heat the articles to temperatures that prevent high residual stresses in the manufactured article. The resulting melt pool shape may be dependent on the beam scan strategies of the present disclosure and prevent the high residual stresses in the additively manufactured article. Without wishing to be bound by theory, it is believed that the additively manufactured articles of the present disclosure comprising a high gamma-prime volume fraction are superior to articles manufactured via existing additive manufacturing methods in part due to lower levels of residual stress after additive manufacturing. In particular, it is believed that high residual stress levels may, upon subjecting the articles to heat treatment to further modify the microstructure subsequent to additive manufacturing, result in recrystallization thereby destroying the grain microstructure achieved via additive manufacturing. The additively manufactured articles of the present disclosure are able to maintain the grain microstructure achieved via additive manufacturing, despite being subjected to heat treatment conditions that would otherwise be expected to result in recrystallization. Moreover, in embodiments of the additively manufactured articles discussed herein having a directionally solidified columnar grain structure, the retention of this grain structure after heat treatment is believed partially attributable to the low levels of residual stress achieved with the additive manufacturing methods of the present disclosure.

Melt parameters of the present disclosure may include, but are not limited to, the beam volume energy, beam power, line offset, beam velocity, focal spot size, focus offset, layer thickness, and, in embodiments employing point-based beam scan strategies, point distance, point exposure time, and point order. It has been found that these parameters may be adjusted to facilitate the additive manufacturing of superalloy components having anisotropic microstructures with a high gamma-prime volume fraction.

The power output of the energy beam may be adjusted to control the heat flux to the surface layer of the powder bed. In embodiments, the power output of the energy beam may be greater than or equal to 50 Watts (W) and less than or equal to 6000 W, greater than or equal to 300 W and less than or equal to 3000 W, greater than or equal to 300 W and less than or equal to 2000 W, greater than or equal to 300 W and less than or equal to 1500 W, greater than or equal to 300 W and less than or equal to 1200 W, greater than or equal to 300 W and less than or equal to 1000 W, greater than or equal to 300 W and less than or equal to 800 W, greater than or equal to 300 W and less than or equal to 750 W, greater than or equal to 350 W and less than or equal to 750 W, greater than or equal to 350 W and less than or equal to 700 W, greater than or equal to 400 W and less than or equal to 700 W, greater than or equal to 400 W and less than or equal to 650 W, greater than or equal to 450 W and less than or equal to 650 W, greater than or equal to 450 W and less than or equal to 625 W, greater than or equal to 475 W and less than or equal to 625 W, greater than or equal to 475 W and less than or equal to 600 W, or greater than or equal to 480 W and less than or equal to 600 W. The power output of the energy beam may be adjusted depending on other parameters of the beam scan strategy as well as the layer thickness.

The line offset of the energy beam corresponds to the distance between successive beam paths in which the energy beam is traversed across the surface layer of the powder bed. In embodiments, the line offset of the energy beam may be greater than or equal to 50 $\mu$m and less than or equal to 500 $\mu$m, greater than or equal to 50 $\mu$m and less than or equal to 450 $\mu$m, greater than or equal to 75 $\mu$m and less than or equal to 450 $\mu$m, greater than or equal to 75 $\mu$m and less than or equal to 400 $\mu$m, greater than or equal to 100 $\mu$m and less than or equal to 400 $\mu$m, greater than or equal to 100 $\mu$m and less than or equal to 350 $\mu$m, greater than or equal to 125 $\mu$m and less than or equal to 350 $\mu$m, greater than or equal to 125 $\mu$m and less than or equal to 300 $\mu$m, or greater than or equal to 150 $\mu$m and less than or equal to 300 $\mu$m. In combination with other parameters of the beam scan strategy including the power output of the energy beam, the line offset may be adjusted to control the width and depth of the melt pool as well as with the solidification conditions including temperature gradients and solidification velocities.

In embodiments, the beam velocity of the energy beam may be greater than or equal to 50 mm/s and less than or equal to 20,000 mm/s. In embodiments, the beam velocity of the energy beam may be greater than or equal to 50 mm/s and less than or equal to 1000 mm/s, greater than or equal to 50 mm/s and less than or equal to 950 mm/s, greater than or equal to 100 mm/s and less than or equal to 950 mm/s, greater than or equal to 100 mm/s and less than or equal to 900 mm/s, greater than or equal to 150 mm/s and less than or equal to 900 mm/s, greater than or equal to 150 mm/s and less than or equal to 875 mm/s, greater than or equal to 200 mm/s and less than or equal to 875 mm/s, or greater than or equal to 250 mm/s and less than or equal to 875 mm/s. In combination with other parameters of the beam scan strategy, the beam velocity of the energy beam may be adjusted to control the width and depth of the melt pool as well as with the solidification conditions including temperature gradients and solidification velocities.

In embodiments, the additively manufactured articles of the present disclosure may be produced using thermally adaptive point-based beam scan strategies wherein the point distance, point exposure time, and point order (e.g., uniform or random) are adjusted to control the shape and size of the melt pool along with the solidification conditions including thermal gradients and solidification velocities. The point exposure time may be greater than or equal to 0.01 milliseconds (ms) per point and less than or equal to 10 ms per point. The point distance of the energy beam may be greater than or equal to 50 $\mu$m and less than or equal to 500 $\mu$m, greater than or equal to 50 $\mu$m and less than or equal to 450 $\mu$m, greater than or equal to 75 $\mu$m and less than or equal to 450 $\mu$m, greater than or equal to 75 $\mu$m and less than or equal to 400 $\mu$m, greater than or equal to 100 $\mu$m and less than or equal to 400 $\mu$m, greater than or equal to 100 $\mu$m and less than or equal to 350 $\mu$m, greater than or equal to 125 $\mu$m and less than or equal to 350 $\mu$m, greater than or equal to 125 $\mu$m and less than or equal to 300 $\mu$m, or greater than or equal to 150 $\mu$m and less than or equal to 300 $\mu$m. In combination with other parameters of the beam scan strategy including the power output of the energy beam, the point distance may be adjusted to control the width and depth of the melt pool as well as with the solidification conditions including temperature gradients and solidification velocities.

In embodiments, the full-width-half-maximum (FWHM) of the energy beam, that is, the width of the energy beam at a position along the beam path corresponding to half the peak intensity of the energy beam, may be adjusted to control the shape and size of the melt pool. In embodiments, the FWHM of the energy beam may be greater than or equal to 50 $\mu$m and less than or equal to 2,000 $\mu$m, greater than or equal to 50 $\mu$m and less than or equal to 1,500 $\mu$m, greater than or equal to 100 $\mu$m and less than or equal to 1,500 $\mu$m, greater than or equal to 100 $\mu$m and less than or equal to 1,000 $\mu$m, greater

than or equal to 150 μm and less than or equal to 1,000 μm, greater than or equal to 150 μm and less than or equal to 800 μm, greater than or equal to 200 μm and less than or equal to 800 μm, or greater than or equal to 200 μm and less than or equal to 500 μm. The focus offset of the energy beam may be adjusted to control the spot size of the energy beam and the depth of the melting pool.

In embodiments, each successive powder layer of the additive manufacturing process may have a layer thickness greater than or equal to 10 μm and less than or equal to 200 μm, although the thickness may be selected based on any number of parameters and may be any suitable size. In embodiments, the layer thickness may be greater than or equal to 20 μm and less than or equal to 200 μm, greater than or equal to 20 μm and less than or equal to 180 μm, greater than or equal to 20 μm and less than or equal to 160 μm, greater than or equal to 20 μm and less than or equal to 140 μm, greater than or equal to 20 μm and less than or equal to 120 μm, greater than or equal to 30 μm and less than or equal to 120 μm, greater than or equal to 30 μm and less than or equal to 100 μm, greater than or equal to 30 μm and less than or equal to 90 μm, greater than or equal to 40 μm and less than or equal to 90 μm, greater than or equal to 40 μm and less than or equal to 80 μm, greater than or equal to 50 μm and less than or equal to 80 μm, or greater than or equal to 50 μm and less than or equal to 70 μm.

The volume energy may be defined as shown below in Equation 1.

$$Volume\ energy = \frac{acceleration\ voltage \times beam\ current}{beam\ velocity \times line\ offset \times layer\ thickness} \qquad \text{Equation 1}$$

In embodiments of the additively manufactured articles produced via point-based beam scan strategies, the volume energy may be defined as shown below in Equation 2.

$$Volume\ energy = \frac{acceleration\ voltage \times beam\ current \times \left(\frac{points}{area}\right) \times point\ exposure\ time}{layer\ thickness} \qquad \text{Equation 2}$$

In embodiments, the volume energy may be greater than or equal to 10 J/mm$^3$ and less than or equal to 200 J/mm$^3$, greater than or equal to 50 J/mm$^3$ and less than or equal to 200 J/mm$^3$, greater than or equal to 50 J/mm$^3$ and less than or equal to 190 J/mm$^3$, greater than or equal to 55 J/mm$^3$ and less than or equal to 190 J/mm$^3$, greater than or equal to 55 J/mm$^3$ and less than or equal to 180 J/mm$^3$, greater than or equal to 60 J/mm$^3$ and less than or equal to 180 J/mm$^3$, greater than or equal to 60 J/mm$^3$ and less than or equal to 170 J/mm$^3$, greater than or equal to 65 J/mm$^3$ and less than or equal to 170 J/mm$^3$, greater than or equal to 65 J/mm$^3$ and less than or equal to 160 J/mm$^3$, greater than or equal to 70 J/mm$^3$ and less than or equal to 160 J/mm$^3$, greater than or equal to 70 J/mm$^3$ and less than or equal to 150 J/mm$^3$, greater than or equal to 75 J/mm$^3$ and less than or equal to 150 J/mm$^3$, greater than or equal to 75 J/mm$^3$ and less than or equal to 140 J/mm$^3$, or greater than or equal to 80 J/mm$^3$ and less than or equal to 140 J/mm$^3$. In combination with other parameters of the beam scan strategy including the power output of the energy beam, the line offset may be adjusted to control the width and depth of the melt pool as well as with the solidification conditions including temperature gradients and solidification velocities.

In embodiments, the melt parameters of the additive manufacturing process may be adjusted to shape the melt pool so as to produce a variety of microstructures. In particular, the melt parameters of the additive manufacturing process may be adjusted so as to produce melt pools having a melt pool depth greater than or equal to 50 μm and less than or equal to 500 μm, greater than or equal to 50 μm and less than or equal to 300 μm, greater than or equal to 50 μm and less than or equal to 290 μm, greater than or equal to 60 μm and less than or equal to 290 μm, greater than or equal to 60 μm and less than or equal to 280 μm, greater than or equal to 70 μm and less than or equal to 280 μm, greater than or equal to 70 μm and less than or equal to 270 μm, greater than or equal to 80 μm and less than or equal to 270 μm, greater than or equal to 80 μm and less than or equal to 260 μm, greater than or equal to 90 μm and less than or equal to 260 μm, greater than or equal to 90 μm and less than or equal to 250 μm, greater than or equal to 100 μm and less than or equal to 250 μm, greater than or equal to 100 μm and less than or equal to 240 μm, greater than or equal to 100 μm and less than or equal to 230 μm, greater than or equal to 110 μm and less than or equal to 230 μm, or greater than or equal to 110 μm and less than or equal to 220 μm.

In embodiments, the melt pool parameters of the additive manufacturing process may be adjusted so as to produce melt pools having a melt pool width greater than or equal to 150 μm and less than or equal to 1500 μm, greater than or equal to 200 μm and less than or equal to 1300 μm, greater than or equal to 300 μm and less than or equal to 1100 μm, greater than or equal to 400 μm and less than or equal to 900 μm, greater than or equal to 460 μm and less than or equal to 840 μm, greater than or equal to 460 μm and less than or equal to 820 μm, greater than or equal to 480 μm and less than or equal to 820 μm, greater than or equal to 480 μm and less than or equal to 800 μm, greater than or equal to 500 μm and less than or equal to 800 μm, greater than or equal to 500 μm and less than or equal to 780 μm, or greater than or equal to 520 μm and less than or equal to 780 μm.

As discussed above, it has been found that a more equiaxed polycrystalline microstructure i.e., a microstructure having grains with an average aspect ratio of less than or equal to 5, may be achieved by adjusting the melt parameters of the additive manufacturing process so as to form distinct and deep melt pools. To promote a more equiaxed grain microstructure in the additively manufactured articles of the present disclosure, the melt parameters of the additive manufacturing process may be adjusted so as to produce melt pools having a melt pool depth greater than or equal to 180 μm and less than or equal to 240 μm, greater than or equal to 180 μm and less than or equal to 235 μm, greater than or equal to 185 μm and less than or equal to 235 μm, greater than or equal to 185 μm and less than or equal to 230 μm, greater than or equal to 190 μm and less than or equal to 230 μm, greater than or equal to 190 μm and less than or equal to 225 μm, greater than or equal to 195 μm and less than or equal to 225 μm, greater than or equal to 195 μm and less than or equal to 220 μm, or greater than or equal to 200 μm and less than or equal to 220 μm. With regards to the melt pool width, to promote a more equiaxed grain microstructure in the additively manufactured articles of the present disclosure, the melt parameters of the additive manufacturing process may be adjusted so as to produce melt pools having a melt pool width greater than or equal to 500 μm and less than or equal to 620 μm, greater than or equal to 500 μm and less than or equal to 600 μm, greater than or equal to 520 μm and less than or equal to 600 μm, greater than or equal to 520 μm and less than or equal to 580 μm, or greater than or equal to 540 μm and less than or equal to 580 μm.

To promote a hybrid grain microstructure comprising both columnar grains and grains with a low aspect ratio, the melt parameters of the additive manufacturing process may be adjusted so as to produce melt pools having a melt pool depth greater than or equal to 115 μm and less than or equal to 180 μm, greater than or equal to 115 μm and less than or equal to 175 μm, greater than or equal to 120 μm and less than or equal to 175 μm, greater than or equal to 120 μm and less than or equal to 170 μm, greater than or equal to 125 μm and less than or equal to 170 μm, greater than or equal to 125 μm and less than or equal to 165 μm, greater than or equal to 130 μm and less than or equal to 165 μm, greater than or equal to 130 μm and less than or equal to 160 μm, or greater than or equal to 135 μm and less than or equal to 160 μm. With regards to the melt pool width, to promote a hybrid grain microstructure, the melt parameters of the additive manufacturing process may be adjusted so as to produce melt pools having a melt pool width greater than or equal to 580 μm and less than or equal to 700 μm, greater than or equal to 580 μm and less than or equal to 680 μm, greater than or equal to 600 μm and less than or equal to 680 μm, greater than or equal to 600 μm and less than or equal to 660 μm, greater than or equal to 620 μm and less than or equal to 660 μm, greater than or equal to 620 μm and less than or equal to 650 μm.

To promote a directionally solidified anisotropic microstructure comprising columnar grains, the melt parameters of the additive manufacturing process may be adjusted so as to produce melt pools having a melt pool depth greater than or equal to 90 μm and less than or equal to 190 μm, greater than or equal to 90 μm and less than or equal to 185 μm, greater than or equal to 95 μm and less than or equal to 185 μm, greater than or equal to 95 μm and less than or equal to 180 μm, greater than or equal to 100 μm and less than or equal to 180 μm, greater than or equal to 100 μm and less than or equal to 175 μm, greater than or equal to 105 μm and less than or equal to 175 μm, greater than or equal to 105 μm and less than or equal to 170 μm, or greater than or equal to 110 μm and less than or equal to 170 μm. With regards to the melt pool width, to promote a directionally solidified anisotropic microstructure comprising columnar grains, the melt parameters of the additive manufacturing process may be adjusted so as to produce melt pools having a melt pool width greater than or equal to 440 μm and less than or equal to 860 μm, greater than or equal to 440 μm and less than or equal to 840 μm, greater than or equal to 460 μm and less than or equal to 840 μm, greater than or equal to 460 μm and less than or equal to 820 μm, greater than or equal to 480 μm and less than or equal to 820 μm, greater than or equal to 480 μm and less than or equal to 800 μm, greater than or equal to 500 μm and less than or equal to 800 μm, greater than or equal to 500 μm and less than or equal to 780 μm, or greater than or equal to 520 μm and less than or equal to 780 μm.

As mentioned above, the microstructure of the additively manufactured articles disclosed herein may be controlled by adjusting the melt parameters of the additive manufacturing process. The melt parameters may determine the shape of the melt pool, the solidification velocity, and the temperature gradients within melt pool, each of which influences the evolution of the microstructure. With regards to the shape of the melt pool, it has been found that an equiaxed polycrystalline microstructure may be achieved by adjusting the melt parameters of the additive manufacturing process so as to form distinct and deep melt pools. In contrast to this, it has been found that a highly anisotropic and fully columnar microstructure may be achieved by adjusting the melt parameters of the additive manufacturing process so as to form a broad melt pool.

Without wishing to be bound by theory, the differing resultant microstructures are believed to be related to the angle of the liquid/solid interface of the melt pool relative to the planar surface of the powder bed. The temperature gradient and direction of solidification is generally perpendicular to the liquid/solid interface such that a high angle of the liquid/solid interface, e.g., as present in sharp and deep melt pools, suppresses epitaxial growth and favors the formation of new grains and an equiaxed microstructure. On the other hand, the low angle of the liquid/solid interface found in shallow and broad melt pools may favor epitaxial growth leading to distinct columnar grains and a directionally solidified microstructure. Finally, a liquid/solid interface having an angle with respect to the planar surface of the powder bed somewhere in between a low angle and a high angle may lead to a hybrid microstructure comprising both columnar grains and grains with a low aspect ratio.

In embodiments, the additively manufactured articles of the present disclosure may comprise a superalloy composition and a microstructure comprising a gamma-prime phase making up greater than or equal to 25% by volume of the microstructure, greater than or equal to 30% by volume of the microstructure, greater than or equal to 35% by volume of the microstructure, greater than or equal to 40% by volume of the microstructure, greater than or equal to 45% by volume of the microstructure, greater than or equal to 50% by volume of the microstructure, greater than or equal to 55% by volume of the microstructure, greater than or equal to 60% by volume of the microstructure, greater than or equal to 65% by volume of the microstructure, or greater than or equal to 70% by volume of the microstructure. The gamma-prime volume fraction of the microstructure may be determined by manual or automatic image analysis methods known in the art, such as, for example, the Fullman-Intercept method as described in Seher et al., "Quantitative Metallography of the Age Hardening Precipitate in Superalloys by Replica Electron Microscopy," Symposium on Stereology and Quantitative Metallography, pp. 119-137 (1972).

The superalloy composition of the additively manufactured article may be a nickel-based or cobalt-based superalloy composition. In embodiments, the superalloy composition may comprise a titanium content and an aluminum content such that $w_{Al} + w_{Ti} >= 4$ wt.%, where $w_{Al}$ corresponds to a weight percentage of aluminum in the superalloy composition and $w_{Ti}$ corresponds to a weight percentage of titanium in the superalloy composition. In embodiments, the superalloy composition may comprise a titanium content and an aluminum content such that $w_{Al} + w_{Ti} >= 4.0$ wt.%, $w_{Al} + w_{Ti} >= 4.1$ wt.%, $w_{Al} + w_{Ti} >= 4.2$ wt.%, $w_{Al} + w_{Ti} >= 4.3$ wt.%, $w_{Al} + w_{Ti} >= 4.4$ wt.%, $w_{Al} + w_{Ti} >= 4.5$ wt.%, $w_{Al} + w_{Ti} >= 4.6$ wt.%, $w_{Al} + w_{Ti} >= 4.7$ wt.%, $w_{Al} + w_{Ti} >= 4.8$ wt.%, $w_{Al} + w_{Ti} >= 4.9$ wt.%, $w_{Al} + w_{Ti} >= 5.0$ wt.%, $w_{Al} + w_{Ti} >= 5.1$ wt.%, $w_{Al} + w_{Ti} >= 5.2$ wt.%, $w_{Al} + w_{Ti} >= 5.3$ wt.%, $w_{Al} + w_{Ti} >= 5.4$ wt.%, $w_{Al} + w_{Ti} >= 5.5$ wt.%, $w_{Al} + w_{Ti} >= 5.6$ wt.%, $w_{Al} + w_{Ti} >= 5.7$ wt.%, $w_{Al} + w_{Ti} >= 5.8$ wt.%, $w_{Al} + w_{Ti} >= 5.9$ wt.%, or $w_{Al} + w_{Ti} >= 6.0$ wt.%. In embodiments, the superalloy composition may comprise a weight percentage of chromium that is less than or equal to 13.5 wt.%, less than or equal to 13.0 wt.%, less than or equal to 12.5 wt.%, less than or equal to 12.0 wt.%, less than or equal to 11.5 wt.%, less than or equal to 11.0 wt.%, less than or equal to 10.5 wt.%, less than or equal to 10.0 wt.%, less than or equal to 9.5 wt.%, or less than or equal to 9.0 wt.%. In embodiments, the weight percentage of chromium in the superalloy composition is greater than or equal to 8.0 wt.% and less than or equal to 9.0 wt.%.

As discussed above, the microstructure of the additively manufactured articles of the present disclosure may be anisotropic and comprise grains having an average grain size and average aspect ratio (i.e., the longest measurement of a grain divided by the measurement of the grain in a direction perpendicular to the direction associated with the longest measurement of the grain) corresponding to columnar-shaped grains. The average grain size and average aspect ratio may be determined by manual or automatic image analysis methods known in the art, such as, for example, according to the procedure set forth in ASTM E112-13 (2021), entitled "Standard Test Methods for Determining Average Grain Size," the entire contents of which are incorporated herein by reference.

In embodiments, the microstructure may comprise grains having an average aspect ratio of greater than or equal to 5, greater than or equal to 6, greater than or equal to 7, greater than or equal to 8, greater than or equal to 9, greater than or equal to 10, greater than or equal to 12, greater than or equal to 14, greater than or equal to 16, greater than or equal to 18, greater than or equal to 20, greater than or equal to 25, greater than or equal to 30, greater than or equal to 35, or greater than or equal to 40.

In embodiments, the grains of the microstructure may have an average aspect ratio of greater than or equal to 5 and less than or equal to 100, greater than or equal to 6 and less than or equal to 100, greater than or equal to 7 and less than or equal to 100, greater than or equal to 8 and less than or equal to 100, greater than or equal to 9 and less than or equal to 100, greater than or equal to 10 and less than or equal to 100, greater than or equal to 12 and less than or equal to 100, greater than or equal to 14 and less than or equal to 100, greater than or equal to 16 and less than or equal to 100, greater than or equal to 18 and less than or equal to 100, greater than or equal to 20 and less than or equal to 100, greater than or equal to 25 and less than or equal to 100, greater than or equal to 30 and less than or equal to 100, greater than or equal to 35 and less than or equal to 100, or greater than or equal to 40 and less than or equal to 100.

In embodiments, the grains of the microstructure may have an average aspect ratio of greater than or equal to 5 and less than or equal to 90, greater than or equal to 5 and less than or equal to 80, greater than or equal to 5 and less than or equal to 70, greater than or equal to 5 and less than or equal to 60, greater than or equal to 5 and less than or equal to 50, greater than or equal to 5 and less than or equal to 40, greater than or equal to 10 and less than or equal to 90, greater than or equal to 10 and less than or equal to 80, greater than or equal to 20 and less than or equal to 80, greater than or equal to 20 and less than or equal to 70, greater than or equal to 30 and less than or equal to 70, greater than or equal to 30 and less than or equal to 60, or greater than or equal to 40 and less than or equal to 60.

Referring again to FIG. 1, the additively manufactured articles of the present disclosure may comprise a build direction height H that is greater than or equal to 20 mm, greater than or equal to 25 mm, greater than or equal to 30 mm, greater than or equal to 35 mm, greater than or equal to 40 mm, greater than or equal to 45 mm, greater than or equal to 50 mm, greater than or equal to 55 mm, greater than or equal to 60 mm, greater than or equal to 65 mm, greater than or equal to 70 mm, greater than or equal to 75 mm, greater than or equal to 80 mm, greater than or equal to 85 mm, greater than or equal to 90 mm, greater than or equal to 95 mm, greater than or equal to 100 mm, greater than or equal to 150 mm, greater than or equal to 200 mm, greater than or equal to 300 mm, greater than or equal to 400 mm, or greater than or equal to 500 mm.

As discussed above, the additively manufactured articles of the present disclosure may, as a result of the advanced beam scan strategies described herein, have high-temperature mechanical properties equal to or better than as-cast and heat-treated materials. In particular, the directionally solidified columnar grain structure of embodiments of the additively manufactured articles of the present disclosure may be able to resist creep damage at high temperatures.

In embodiments, the additively manufactured articles of the present disclosure may comprise a creep rupture life at 980°C and 200 Mpa of at least 1 hour measured in accordance with ISO 204:2009 and parallel to the build direction. In embodiments, the additively manufactured articles may comprise a creep rupture life, measured parallel to the build direction and in accordance with ISO 204:2009 at 980°C and 200 Mpa, of at least 2 hours, at least 3 hours, at least 5 hours, at least 8 hours, at least 10 hours, at least 15 hours, at least 20 hours, at least 25 hours, at least 30 hours, at least 35 hours, at least 40 hours, at least 45 hours, at least 50 hours, at least 60 hours, at least 70 hours, at least 80 hours, at least 90 hours, at least 100 hours, at least 110 hours, or at least 120 hours. In embodiments, the additively manufactured articles may comprise a creep rupture life, measured parallel to the build direction and in accordance with ISO 204:2009 at 980°C and 200 Mpa, of greater than or equal to 1 hour and less than or equal to 20 hours, greater than or equal to 10 hours and less than or equal to 50 hours, greater than or equal to 20 hours and less than or equal to 50 hours, or greater than or equal to 30 hours and less than or equal to 50 hours.

In embodiments, the creep rupture life may depend on, among other factors, the average grain aspect ratio and the average size of the microstructure of the additively manufactured article. In embodiments where the microstructure of the additively manufactured article comprises grains having an average aspect ratio less than or equal to 10 $\mu$m and/or an average grain size less than or equal to 100 $\mu$m, the additively manufactured article may comprise a creep rupture life, measured parallel to the build direction and in accordance with ISO 204:2009 at 980°C and 200 Mpa, of greater than or equal to 1 hour and less than or equal to 20 hours. In embodiments where the microstructure of the additively manufactured article comprises grains having an average aspect ratio greater than 10 $\mu$m and/or an average grain size greater than 100 $\mu$m, the additively manufactured article may comprise a creep rupture life, measured parallel to the build direction and in accordance with ISO 204:2009 at 980°C and 200 Mpa, of greater than 20 hours.

In embodiments, the additively manufactured articles of the present disclosure may comprise a creep rupture strain at 980°C and 200 Mpa of at least 3%, measured in accordance with ISO 204:2009 and parallel to the build direction. In embodiments, the additively manufactured articles may comprise a creep rupture strain, measured parallel to the build direction and in accordance with ISO 204:2009 at 980°C and 200 Mpa, of at least 4%, of at least 5%, of at least 6%, of at least 7%, of at least 8%, of at least 9%, of at least 10%, of at least 12%, of at least 14%, of at least 16%, of at least 18%, or of at least 20%.

In embodiments, the creep rupture strain may depend on the average grain aspect ratio and the average grain size of the microstructure of the additively manufactured article. In embodiments where the microstructure of the additively manufactured article comprises grains having an average aspect ratio less than or equal to 10 $\mu$m and/or an average grain size less than or equal to 100 $\mu$m, the additively manufactured article may comprise a creep rupture strain, measured parallel to the build direction and in accordance with ISO 204:2009 at 980°C and 200 Mpa, of greater than or equal to 3% and less than or equal to 10%. In embodiments where the microstructure of the additively manufactured article comprises grains having an average aspect ratio greater than 10 $\mu$m and/or an average grain size greater than 100 $\mu$m, the additively manufactured article may comprise a creep rupture strain, measured parallel to the build direction and in accordance with ISO 204:2009 at 980°C and 200 Mpa, of greater than 10% and less than or equal to 30%.

The additively manufactured articles of the present disclosure may be subjected to a heat treatment process after the additive manufacturing process has been completed. Requirements for turbine engine components may necessitate a certain gamma-prime precipitate size and carbide morphology. The application of a heat treatment process to the additive manufacturing articles subsequent to the additive manufacturing process may modify the microstructure of the additively manufactured articles so as to fulfill such requirements. The heat treatment may be a standard heat treatment comprising a super-solvus solution heat treatment process followed by a two-step aging procedure. A hot isostatic pressing (HIP) heat treatment, another common requirement for meeting standards for turbine engine components, may be implemented prior to the solution heat treatment and aging procedure.

In embodiments, the heat treatment applied to the additively manufactured articles may be a solution heat treatment process comprising a heat treatment temperature of between 1100°C and 1400°C, between 1120°C and 1380°C, between 1140°C and 1360°C, between 1160°C and 1340°C, between 1160°C and 1320°C, between 1160°C and 1300°C, between 1180°C and 1300°C, between 1200°C and 1300°C, between 1200°C and 1280°C, between 1220°C and 1280°C, between 1220°C and 1260°C, between 1230°C and 1260°C, or between 1230°C and 1250°C. In embodiments, the heat treatment temperature for the solution heat treatment process may be about 1240°C. In embodiments, the solution heat treatment applied to the additively manufactured articles may comprise a holding time less than or equal to 60 minutes, less than or equal to 55 minutes, less than or equal to 50 minutes, less than or equal to 45 minutes, less than or equal to 40 minutes, less than or equal to 35 minutes, or less than or equal to 30 minutes. In embodiments, the solution heat treatment applied to the additively manufactured articles may comprise a holding time of greater than or equal to 15 minutes and less than or equal to 75 minutes, greater than or equal to 20 minutes and less than or equal to 70 minutes, greater than or equal to 25 minutes and less than or equal to 65 minutes, or greater than or equal to 30 minutes and less than or equal to 60 minutes.

In embodiments, the heat treatment applied to the additively manufactured articles may include an aging process. In embodiments, the aging process may be a two-step aging process. The first step of the two-step aging process may comprise an aging temperature of between 1000°C and 1200°C, between 1000°C and 1180°C, between 1020°C and 1180°C, between 1020°C and 1160°C, between 1040°C and 1160°C, between 1040°C and 1140°C, between 1060°C and 1140°C, between 1060°C and 1120°C, between 1060°C and 1100°C, between 1070°C and 1100°C, or between 1070°C and 1090°C. In embodiments, the aging temperature for the first step of the two-step aging process may be about 1080°C. In embodiments, the aging time for the first step of the two-step aging process may between 2.0 hours and 6.0 hours, between 2.5 hours and 6.0 hours, between 2.5 hours and 5.5 hours, between 3.0 hours and 5.5 hours, between 3.0 hours and 5.0 hours, between 3.5 hours and 5.0 hours, between 3.5 hours and 4.5 hours. In embodiments, the aging time for the first step of the two-step aging process may be about 4.0 hours.

The second step of the two-step aging process may comprise an aging temperature of between 800°C and 1000°C, between 800°C and 980°C, between 820°C and 980°C, between 820°C and 960°C, between 840°C and 960°C, between 840°C and 940°C, between 860°C and 940°C, between 860°C and 920°C, between 880°C and 920°C, between 880°C and 910°C, or between 890°C and 910°C. In embodiments, the aging temperature for the second step of the two-step aging process may be about 900°C. In embodiments, the aging time for the second step of the two-step aging process may between 6.0 hours and 10.0 hours, between 6.0 hours and 9.5 hours, between 6.5 hours and 9.5 hours, between 6.5 hours and 9.0 hours, between 7.0 hours and 9.0 hours, between 7.0 hours and 8.5 hours, or between 7.5 hours and 8.5 hours. In embodiments, the aging time for the second step of the two-step aging process may be about 8.0 hours.

In embodiments, a hot isostatic pressing (HIP) heat treatment may be implemented prior to the solution heat treatment and aging procedure. A hot isostatic pressing (HIP) heat treatment may mitigate remaining defects, or further reduce their size and amount, leading to superior EBM material properties. The HIP heat treatment may comprise a HIP temperature of between 1100°C and 1400°C, between 1120°C and 1380°C, between 1140°C and 1360°C, between 1160°C and 1340°C, between 1160°C and 1320°C, between 1160°C and 1300°C, between 1180°C and 1300°C, between 1200°C and 1300°C, between 1200°C and 1280°C, between 1220°C and 1280°C, between 1220°C and 1260°C, between 1230°C and 1260°C, or between 1230°C and 1250°C. In embodiments, the HIP heat treatment temperature for the solution heat treatment process may be about 1240°C or about 1245°C. In embodiments, the HIP heat treatment time may between 2.0 hours and 6.0 hours, between 2.5 hours and 6.0 hours, between 2.5 hours and 5.5 hours, between 3.0 hours and 5.5 hours, between 3.0 hours and 5.0 hours, between 3.5 hours and 5.0 hours, between 3.5 hours and 4.5 hours. In embodiments, the aging time for the first step of the two-step aging process may be about 4.0 hours. In embodiments the HIP heat treatment pressure may be between 500 bar (50 Mpa) and 2000 bar (200 Mpa), between 750 bar (75 Mpa) and 1750 bar (175 Mpa), or between 1000 bar (100 Mpa) and 1500 bar (150 Mpa). The additively manufactured article may be cooled following the HIP heat treatment with or without quenching, e.g., air and/or argon quenching.

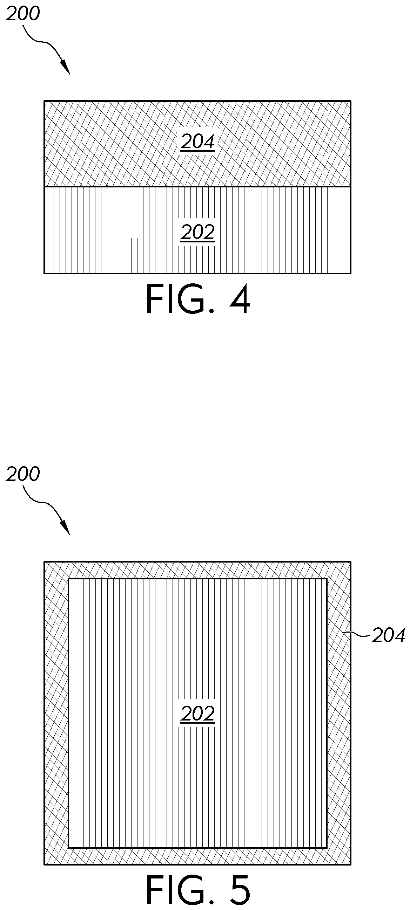

With reference now to FIG. 4, additively manufactured article 200 of the present disclosure may comprise a superalloy composition and a graded microstructure. The graded microstructure may comprise a gamma-prime phase that makes up greater than or equal to 35% by volume of the graded microstructure. The graded microstructure may comprise a plurality of sections, wherein each section comprises grains with an average aspect ratio that may be different from an average aspect ratio of other sections of the plurality of sections. Additively manufactured articles of the present disclosure comprising graded microstructures may exhibit local mechanical properties designed for their particular exposure in a particular application. For example, one region of an additively manufactured article with anticipated exposure to a relatively greater level of cyclic loading may benefit from having grains with a relatively smaller average aspect ratio, e.g., equiaxed polycrystalline grains. Other regions of the additively manufactured article, e.g., regions with anticipated exposure to lower levels of cyclic loading, may be designed to exhibit improved resistance to creep and may thus benefit from having grains with a relatively larger average aspect ratio, e.g., directionally solidified columnar grains.

Referring still to FIG. 4, the graded microstructure may comprise a first section 202 comprising first grains and a second section 204 comprising second grains. The additive manufacturing process may form the first section 202 and the second section 204 such that they are arranged with respect to each other and the build plate 18 (see FIG. 1) in any suitable manner. With reference to FIG. 5, in embodiments, the first section 202 may comprise a core of the additively manufactured article 200 and the second section 204 may comprise an outer shell of the additively manufactured article 200. While the embodiment depicted in FIG. 5 shows the outer shell surrounding the core, embodiments of the additively manufactured articles disclosed herein include configurations wherein the second section 204 comprising the outer shell only surrounds a portion of the first section 202 comprising the core.

The first grains may have an average aspect ratio greater than or equal to 5, greater than or equal to 6, greater than or equal to 7, greater than or equal to 8, greater than or equal to 9, greater than or equal to 10, greater than or equal to 12, greater than or equal to 14, greater than or equal to 16, greater than or equal to 18, greater than or equal to 20, greater than or equal to 25, greater than or equal to 30, greater than or equal to 35, or greater than or equal to 40. The second grains may have an average aspect ratio less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. In embodiments, the average aspect ratio of the first grains may be greater than the average aspect ratio of the second grains.

Additively manufactured articles of the present disclosure comprising graded microstructures may be particularly suited for high temperature environments, such as those present in gas turbine engines that are typically greater than or equal to 800°C. For example, the additively manufactured articles comprising graded microstructures may be used as combustor components, airfoils, turbine blades, shrouds, nozzles, heat shields, and vanes. The additively manufactured articles may also be implemented as hardware components of the hot gas flow path in the turbine center frame.

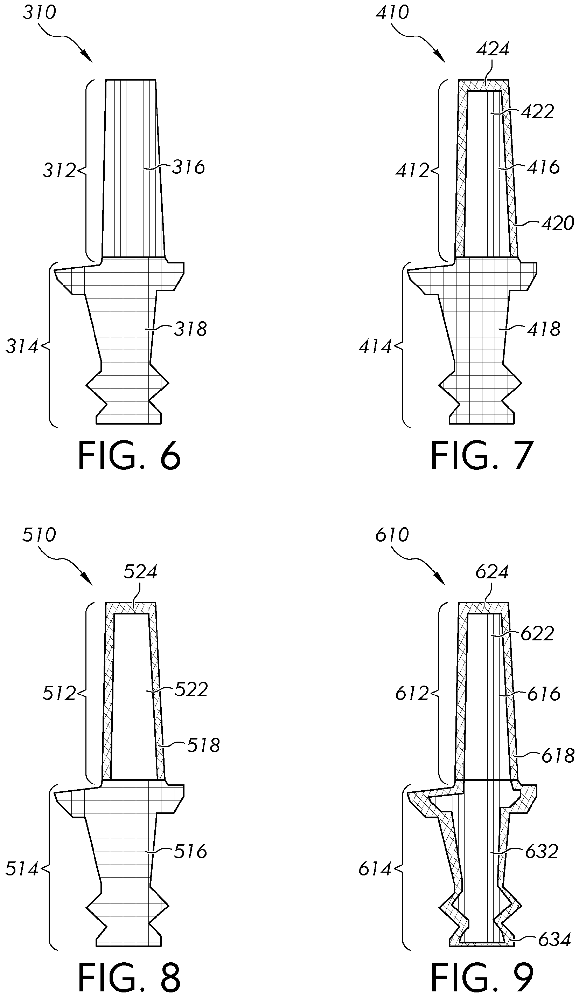

With reference now to FIGS. 6-9, embodiments of the additively manufactured articles formed as exemplary additively manufactured turbine blades will now be described. Each of the additively manufactured turbine blades 310, 410, 510, and 610 shown in FIGS. 6-9, respectively, may comprise a superalloy composition and a graded microstructure comprising a gamma-prime phase that makes up greater than or equal to 25% by volume of the graded microstructure, greater than or equal to 30% by volume of the graded microstructure, greater than or equal to 35% by volume of the graded microstructure, greater than or equal to 40% by volume of the graded microstructure, greater than or equal to 45% by volume of the graded microstructure, greater than or equal to 50% by volume of the graded microstructure, greater than or equal to 55% by volume of the graded microstructure, greater than or equal to 60% by volume of the graded microstructure, greater than or equal to 65% by volume of the graded microstructure, or greater than or equal to 70% by volume of the graded microstructure.

With reference to FIG. 6, in embodiments, additively manufactured turbine blades 310 of the present disclosure may comprise an airfoil 312 connected to a shank 314. The additively manufactured turbine blade 310 may comprise a first section 316 comprising first grains with a first average aspect ratio and a second section 318 comprising second grains with a second average aspect ratio. The second average aspect ratio may be different from the first average aspect ratio. In the embodiment shown in FIG. 6, the airfoil 312 comprises the first section 316 and the shank 314 comprises the second section 318. In embodiments, the first average aspect ratio for the first grains of the first section 316 may be greater than or equal to 5, greater than or equal to 6, greater than or equal to 7, greater than or equal to 8, greater than or equal to 9, greater than or equal to 10, greater than or equal to 12, greater than or equal to 14, greater than or equal to 16, greater than or equal to 18, greater than or equal to 20, greater than or equal to 25, greater than or equal to 30, greater than or equal to 35, or greater than or equal to 40. The second average aspect ratio for the second grains of the second section 318 may be less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. In embodiments, the first average aspect ratio of the first grains of the first section 316 may be greater than the second average aspect ratio of the second grains of the second section 318.

With reference to FIG. 7, in embodiments, additively manufactured turbine blades 410 of the present disclosure may comprise an airfoil 412 connected to a shank 414. The additively manufactured turbine blade 410 may comprise a first section 416 comprising first grains with a first average aspect ratio, a second section 418 comprising second grains with a second average aspect ratio, and a third section 420 comprising third grains with a third average aspect ratio. The first, second, and third average aspect ratios may be different from one another. The airfoil 412 may comprise a core 422 and an outer shell 424 surrounding the core 422. The core 422 may comprise the first section 416, the outer shell 424 may comprise the third section 420, and the shank may comprise the second section 418. The first average aspect ratio of the first grains of the first section 416 may be greater than or equal to 5, greater than or equal to 6, greater than or equal to 7, greater than or equal to 8, greater than or equal to 9, greater than or equal to 10, greater than or equal to 12, greater than or equal to 14, greater than or equal to 16, greater than or equal to 18, greater than or equal to 20, greater than or equal to 25, greater than or equal to 30, greater than or equal to 35, or greater than or equal to 40. The second average aspect ratio of the second grains of the second section 418 may be less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. The third average aspect ratio of the third grains of the third section 420 may be less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. In embodiments, the first average aspect ratio of the first grains of the first section 416 may be greater than the second average aspect ratio of the second grains of the second section 418 and the third average aspect ratio of the third grains of the third section 420. The second average aspect ratio of the second grains of the second section 418 may be greater than the third average aspect ratio of the third grains of the third section 420.

In embodiments, the third grains of the third section 420 may comprise an average grain size of between 0.5 μm and 10 μm, between 0.5 μm and 8 μm, between 1 μm and 8 μm, or between 1 μm and 5 μm. In embodiments, the third grains of the third section 420 may comprise an average grain size of less than 0.5 μm. In embodiments, the third grains of the third section 420 may comprise an average grain size of greater than 10 μm. In embodiments, the third grains of the third section 420 may comprise an average grain size that is less than an average grain size of the second grains of the second section 418.

With reference to FIG. 8, in embodiments, additively manufactured turbine blades 510 of the present disclosure may comprise an airfoil 512 connected to a shank 514. The additively manufactured turbine blade 510 may comprise a first section 516 comprising first grains with a first average aspect ratio and a second section 518 comprising second grains with a second average aspect ratio. The second average aspect ratio of the second grains of the second section 518 may be different from the first average aspect ratio of the first grains of the first section 516. The airfoil 512 may comprise a core 522 and an outer shell 524 surrounding the core 522. The core 522 may comprise a single crystal, the outer shell 524 may comprise the second section 518, and the shank may comprise the first section 516. The first average aspect ratio of the first grains of the first section 516 may be less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. The second average aspect ratio of the second grains of the second section 518 may be less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. In embodiments, the first average aspect ratio of the first grains of the first section 516 may be greater than the second average aspect ratio of the second grains of the second section 518.

In embodiments, the second grains of the second section 518 may comprise an average grain size of between 0.5 μm and 10 μm, between 0.5 μm and 8 μm, between 1 μm and 8 μm, or between 1 μm and 5 μm. In embodiments, the second grains of the second section 518 may comprise an average grain size of less than 0.5 μm. In embodiments, the second grains of the second section 518 may comprise an average grain size of greater than 10 μm. In embodiments, the second grains of the second section 518 may comprise an average grain size that is less than an average grain size of the first grains of the first section 516.

With reference to FIG. 9, in embodiments, additively manufactured turbine blades 610 of the present disclosure may comprise an airfoil 612 connected to a shank 614. The additively manufactured turbine blade 610 may comprise a first section 616 comprising first grains with a first average aspect ratio and a second section 618 comprising second grains with a second average aspect ratio. The second average aspect ratio of the second grains of the second section 618 may be different from the first average aspect ratio of the first grains of the first section 616. The airfoil 612 may comprise an airfoil core 622 and an airfoil shell 624 surrounding the airfoil core 622. The shank 614 may comprise a shank core 632 and a shank shell 634 surrounding the shank core 632. The airfoil core 622 and the shank core 632 may comprise the first section 616 and the airfoil shell 624 and the shank shell 634 may comprise the second section 618. In embodiments, the first average aspect ratio of the first grains of the first section 616 may be greater than or equal to 5, greater than or equal to 6, greater than or equal to 7, greater than or equal to 8, greater than or equal to 9, greater than or equal to 10, greater than or equal to 12, greater than or equal to 14, greater than or equal to 16, greater than or equal to 18, greater than or equal to 20, greater than or equal to 25, greater than or equal to 30, greater than or equal to 35, or greater than or equal to 40. The second average aspect ratio of the second grains of the second section 618 may be less than or equal to 20, less than or equal to 18, less than or equal to 16, less than or equal to 14, less than or equal to 12, less than or equal to 10, less than or equal to 9, less than or equal to 8, less than or equal to 7, less than or equal to 6, less than or equal to 5, less than or equal to 4, less than or equal to 3, or less than or equal to 2. In embodiments, the first average aspect ratio of the first grains of the first section 616 may be greater than the second average aspect ratio of the second grains of the second section 618.

In embodiments, the second grains of the second section 618 may comprise an average grain size of between 0.5 μm and 10 μm, between 0.5 μm and 8 μm, between 1 μm and 8 μm, or between 1 μm and 5 μm. In embodiments, the second grains of the second section 618 may comprise an average grain size of less than 0.5 μm. In embodiments, the second grains of the second section 618 may comprise an average grain size of greater than 10 μm.

In embodiments, the additively manufactured articles of the present disclosure may comprise, in the heat-treated condition, a superalloy composition and a microstructure comprising a gamma-prime phase making up greater than or equal to 25% by volume of the microstructure, greater than or equal to 30% by volume of the microstructure, greater than or equal to 35% by volume of the microstructure, greater than or equal to 40% by volume of the microstructure, greater than or equal to 45% by volume of the microstructure, greater than or equal to 50% by volume of the microstructure, greater than or equal to 55% by volume of the microstructure, greater than or equal to 60% by volume of the microstructure, greater than or equal to 65% by volume of the microstructure, or greater than or equal to 70% by volume of the microstructure.

In embodiments, the grains of the microstructure of the additively manufactured articles in the heat-treated condition, may comprise grains having an average aspect ratio of greater than or equal to 5, greater than or equal to 6, greater than or equal to 7, greater than or equal to 8, greater than or equal to 9, greater than or equal to 10, greater than or equal to 12, greater than or equal to 14, greater than or equal to 16, greater than or equal to 18, greater than or equal to 20, greater than or equal to 25, greater than or equal to 30, greater than or equal to 35, or greater than or equal to 40.

In embodiments, the grains of the microstructure of the additively manufactured articles in the heat-treated condition, may have an average aspect ratio of greater than or equal to 5 and less than or equal to 100, greater than or equal to 6 and less than or equal to 100, greater than or equal to 7 and less than or equal to 100, greater than or equal to 8 and less than or equal to 100, greater than or equal to 9 and less than or equal to 100, greater than or equal to 10 and less than or equal to 100, greater than or equal to 12 and less than or equal to 100, greater than or equal to 14 and less than or equal to 100, greater than or equal to 16 and less than or equal to 100, greater than or equal to 18 and less than or equal to 100, greater than or equal to 20 and less than or equal to 100, greater than or equal to 25 and less than or equal to 100, greater than or equal to 30 and less than or equal to 100, greater than or equal to 35 and less than or equal to 100, or greater than or equal to 40 and less than or equal to 100.

In embodiments, the grains of the microstructure of the additively manufactured articles in the heat-treated condition, may have an average aspect ratio of greater than or equal to 5 and less than or equal to 90, greater than or equal to 5 and less than or equal to 80, greater than or equal to 5 and less than or equal to 70, greater than or equal to 5 and less than or equal to 60, greater than or equal to 5 and less than or equal to 50, greater than or equal to 5 and less than or equal to 40, greater than or equal to 10 and less than or equal to 90, greater than or equal to 10 and less than or equal to 80, greater than or equal to 20 and less than or equal to 80, greater than or equal to 20 and less than or equal to 70, greater than or equal to 30 and less than or equal to 70, greater than or equal to 30 and less than or equal to 60, or greater than or equal to 40 and less than or equal to 60.

Referring again to FIG. 1, the additively manufactured articles of the present disclosure may comprise, in the heat-treated condition, a build direction height H that is greater than or equal to 25 mm, greater than or equal to 30 mm, greater than or equal to 35 mm, greater than or equal to 40 mm, greater than or equal to 45 mm, greater than or equal to 50 mm, greater than or equal to 55 mm, greater than or equal to 60 mm, greater than or equal to 65 mm, greater than or equal to 70 mm, greater than or equal to 75 mm, greater than or equal to 80 mm, greater than or equal to 85 mm, greater than or equal to 90 mm, greater than or equal to 95 mm, greater than or equal to 100 mm, greater than or equal to 150 mm, greater than or equal to 200 mm, greater than or equal to 300 mm, greater than or equal to 400 mm, or greater than or equal to 500 mm.

## EXAMPLES

The following examples illustrate features of the present disclosure but are not intended to limit the scope of the disclosure. The following examples are directed to the fabrication of Alloy 247 using EBM processes. Resulting microstructures and mechanical properties for as-built and heat-treated conditions are discussed.

### *Materials and Methods*

The powder used in these examples was a gas atomized Alloy 247 powder provided by *Praxair Surface Technologies* (Ni-335-7). The particle size distribution was measured using a Malvern Mastersizer 3000 laser diffraction system to $D_{10} = 46$ μm; $D_{50} = 68$ μm and $D_{90} = 100$ μm.

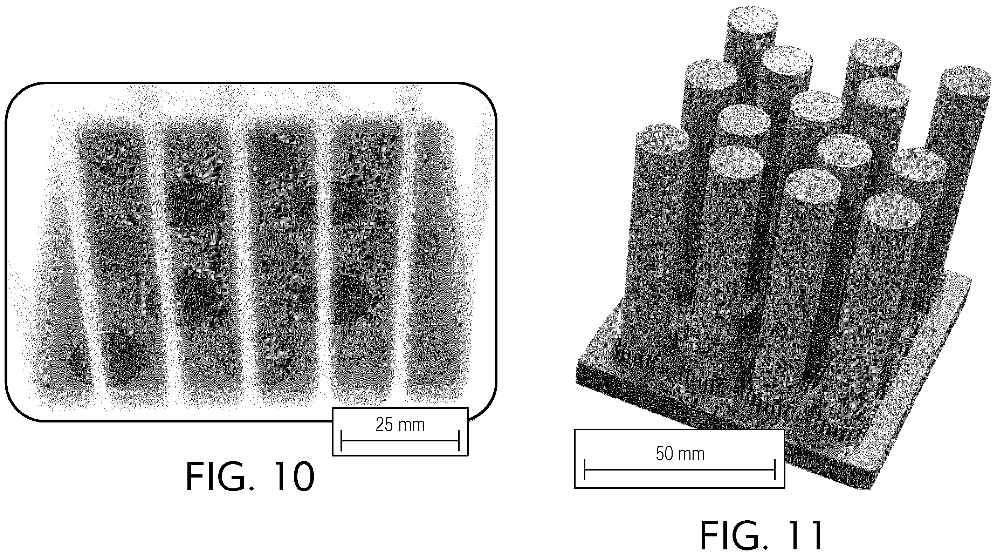

The powder was processed in a modified GE Additive ArcamEBM Q10plus machine. The standard Q10plus Electron Beam Unit (EBU) was replaced by a new generation EBU which is standard for state of the art ArcamEBM SpectraH systems. The system operated under controlled $2 \times 10^{-3}$ mbar He atmosphere, 60 kV acceleration voltage and layer thicknesses of 50 and 70 μm. The specimen temperature was constantly kept > 1000 °C during the build process using a defocused e-beam for build surface Preheating and Heating during the melt process. FIG. 10 shows a snapshot image of the EBM process after material consolidation and visualizes the elevated process temperatures. Mechanical test specimens on a buildplate after powder removal are illustrated in FIG. 11.

For mechanical properties evaluation and microstructure evolution investigations, round shaped specimens with a diameter of Ø = 15 mm and sample height *h* = 75 mm were built on a stainless-steel build plate utilizing pin support structures.

All specimens were produced by varying normalized beam velocity v between 500 and 800 mm/s, focus offset between 15 and 35 mA, and the volume energy between 80 and 135 J/mm³.

For investigation of the microstructure evolution, the melt parameter sets shown in Table 1 were applied.

Table 1

| Melt Parameter Set | Volume Energy [J/mm$^3$] | Beam Power [W] | Line Offset [μm] | Beam Velocity [mm/s] | Focus Offset [mA] | Layer Thickness [μm] |
|---|---|---|---|---|---|---|
| 1 | 120 | 600 | 200 | 500 | 15 | 50 |
| 2 | 90 | 600 | 200 | 667 | 15 | 50 |
| 3 | 106 | 596 | 150 | 750 | 15 | 50 |
| 4 | 94 | 604 | 150 | 857 | 15 | 50 |
| 5 | 135 | 540 | 100 | 800 | 15 | 50 |
| 6 | 80 | 480 | 300 | 400 | 35 | 50 |

For microstructural evaluation of the as-built and heat-treated specimens, metallographic cross-sections were prepared. To reveal microstructure features, a V2A etchant (100 cm$^3$ HCl, 100 cm$^3$ H$_2$O, 10 cm$^3$ HNO$_3$, 0.2 to 2 cm$^3$ Dr. Vogels Sparbeize) heated to 70 °C was used for sample contrasting. Imaging was performed using a DM6M optical microscope form Leica and a Phenom XL tabletop SEM.

Creep-rupture tests on DS material according to ISO 204:2009 were conducted at Element Materials Technology Pilsen, Czech Republic. Tests were performed in the temperature range of 760°C to 980°C and 100 to 690 MPa stress regime, respectively.

*Results*

The produced specimens are technically dense (specimen bulk material density > 99.8 pct) and no critical cracks could be detected. A defect density < 0.15 1/mm and defects with feret diameters ≤ 150 μm were rated as tolerable.

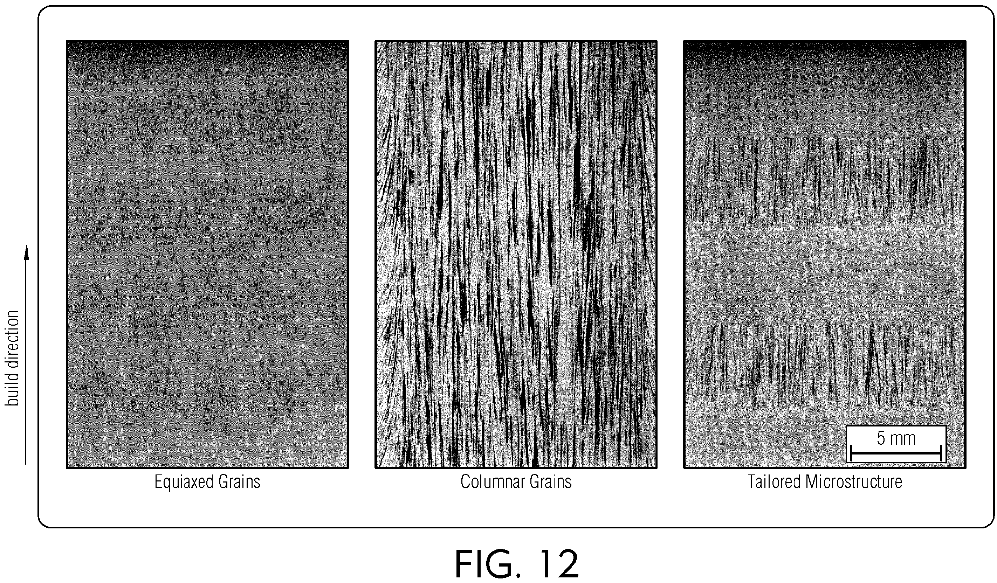

FIG. 12 shows EBM Alloy 247 grain microstructures within specimens with a diameter of Ø = 15 mm. As discussed above, the melt parameters may define the melt pool shape, solidification velocity, and temperature gradients, and control whether a polycrystalline and equiaxed (left) or a highly anisotropic columnar (center) grain microstructure is produced. Local tailoring of the microstructure was achieved as well (right). The grain microstructure could be controlled from equiaxed to columnar grains by adapting melt parameters as they define the melt pool shape, solidification velocity, and temperature gradients. The polycrystalline material revealed equiaxed and isotropic grains, while the columnar material was highly anisotropic. The ability to control the degree of grain anisotropy enabled the opportunity for an *in-situ* tailoring the microstructure on demand within a component such as a turbine blade.

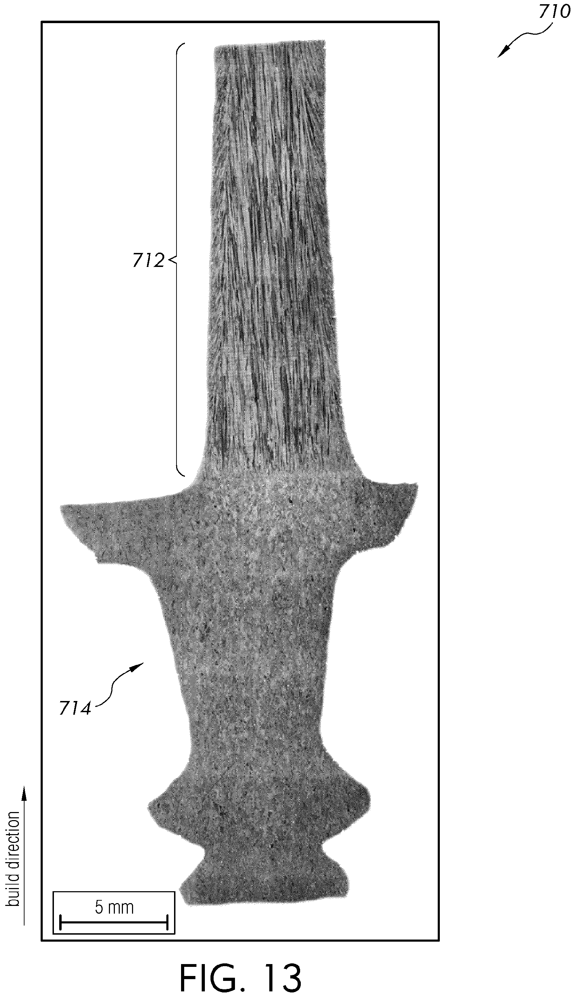

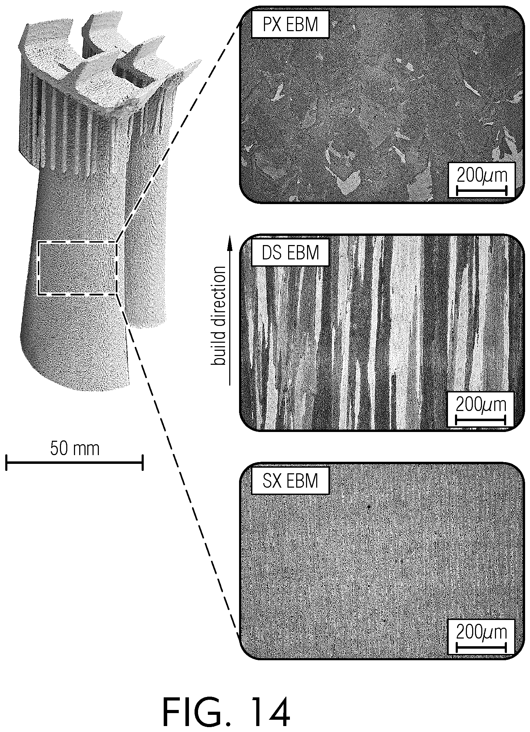

FIG. 13 shows a tailored microstructure for an additively manufactured turbine blade 710 of the present disclosure. The airfoil 712 of the turbine blade 710 comprises a directionally solidified columnar grain microstructure and the shank 714 of the turbine blade 710 comprises an equiaxed polycrystalline microstructure. FIG. 14 shows a portion of an additively manufactured turbine blade produced in accordance with the present disclosure. The three microstructure images in FIG. 14 show the potential for unique tailored or gradient microstructures on demand in turbine blades using EBM.

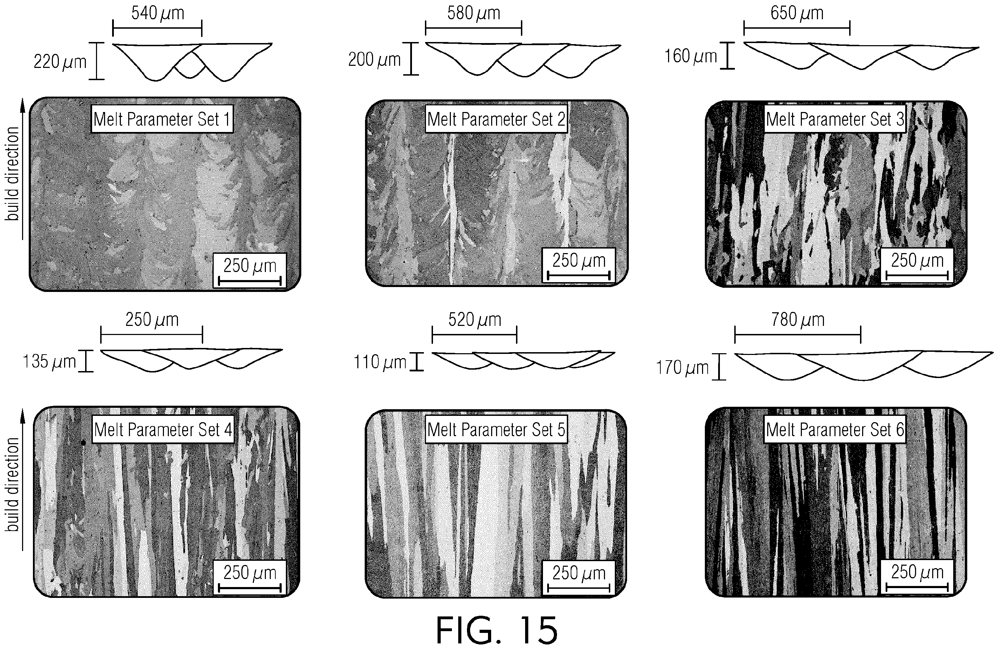

For investigation of the grain microstructure evolution during processing, the resulting melt pool shape is of particular importance and was determined for melt parameter sets 1-6 (see Table 1 above) in the last melted layer using etched longitudinal cross-sections. The determined melt pool shape for each of the melt parameter sets is compared to the corresponding bulk microstructure of each specimen in FIG. 15. If melt parameter sets leading to a distinct sharp and deep melt pool (melt parameter sets 1 and 2) are used, a polycrystalline microstructure was achieved. The mean grain size for poly crystalline material in this study was ~35 μm containing grains between 3 to 700 μm. In contrast to this, if a plain and broad melt pool was generated (melt parameter sets 5 and 6), a highly anisotropic and fully columnar microstructure was achieved. Melt parameter sets 3 and 4 led to a hybrid microstructure containing fractions of columnar and equiaxed grains.

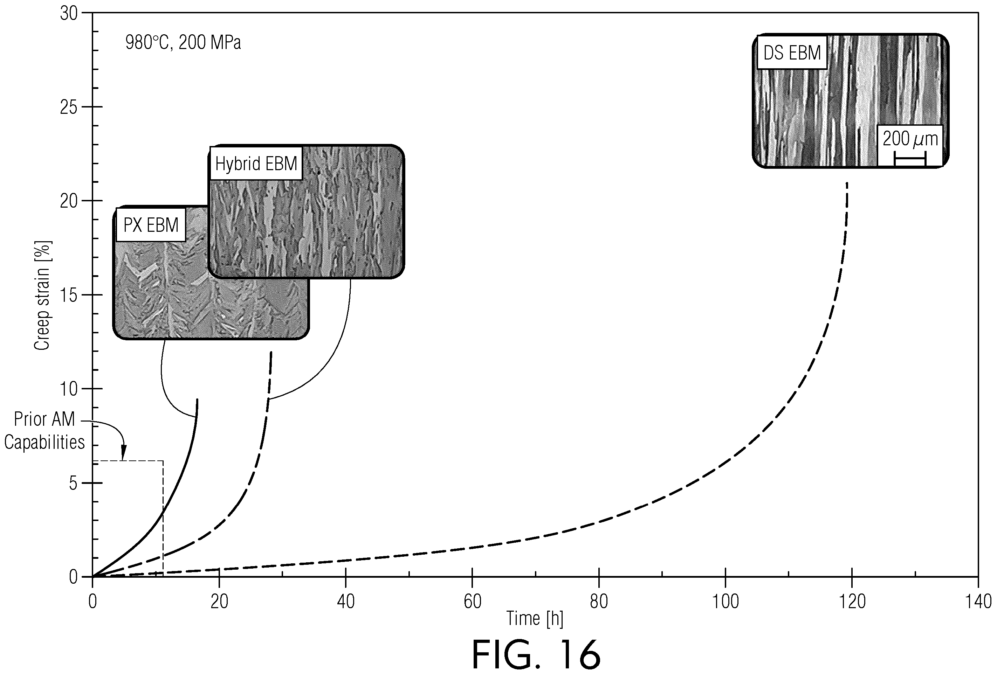

FIG. 16 is a chart showing the creep-rupture test results for various additively manufactured articles of the present disclosure. The inset microscopy images are placed adjacent to their corresponding creep strain curves. The dashed box in the lower left corner of the chart in FIG. 16 represents the creep property limits for additively manufactured articles produced using existing additive manufacturing methods. As can be seen, the additively manufactured articles of the present disclosure comprising a directionally solidified columnar grain structure exhibit superior creep properties compared to previous additively manufactured articles. Table 2 below shows the melt parameters for the beam scan strategies used to produce the EBM alloys corresponding to the creep test results shown in FIG. 16.

Table 2

| EBM Alloy (FIG. 16) | Volume Energy [J/mm³] | Beam Power [W] | Line Offset [µm] | Beam Velocity [mm/s] | Focus Offset [mA] | Layer Thickness [µm] |
|---|---|---|---|---|---|---|
| PX EBM | 120 | 600 | 200 | 500 | 15 | 50 |
| Hybrid EBM | 106 | 596 | 150 | 750 | 15 | 50 |
| DS EBM | 137 | 480 | 200 | 250 | 30 | | 70 |

The above embodiments, and the features of those embodiments, are exemplary and can be provided alone or in any combination with any one or more features of other embodiments provided herein without departing from the scope of the disclosure.

It will be apparent to those skilled in the art that various modifications and variations can be made to the present disclosure without departing from the spirit and scope of the disclosure. Thus, it is intended that the present disclosure cover the modifications and variations of this disclosure provided they come within the scope of the appended claims and their equivalents.

Further aspects of the disclosure are provided by the subject matter of the following clauses:

An additively manufactured article comprising: a superalloy composition; and a microstructure comprising: a gamma-prime phase, wherein the gamma-prime phase is greater than or equal to 35% by volume of the microstructure; and grains, the grains having an average aspect ratio of greater than or equal to 5.

The additively manufactured article as described in the preceding clause, wherein the additively manufactured article is manufactured using an electron beam melting process.

The additively manufactured article as described in any of the preceding clauses, wherein the additively manufactured article comprises a build direction height of greater than or equal to 20 mm.

The additively manufactured article as described in any of the preceding clauses, wherein the additively manufactured article comprises a rupture life at 980°C and 200 MPa of at least 10 hours measured in accordance with ISO 204:2009.

The additively manufactured article as described in any of the preceding clauses, wherein the additively manufactured article comprises a rupture strain at 980°C and 200 MPa of at least 4% measured in accordance with ISO 204:2009.

An additively manufactured article comprising: a superalloy composition; and a graded microstructure comprising: a gamma-prime phase, wherein the gamma-prime phase is greater than or equal to 35% by volume of the graded microstructure; a first section comprising first grains with a first average aspect ratio of greater than or equal to 5; and a second section comprising second grains with a second average aspect ratio of less than 5.

The additively manufactured article as described in any of the preceding clauses, wherein the first section comprises a core of the additively manufactured article and the second section comprises an outer shell of the additively manufactured article.

The additively manufactured article as described in any of the preceding clauses, wherein the additively manufactured article comprises a build direction height of greater than or equal to 20 mm.

The additively manufactured article as described in any of the preceding clauses, wherein the superalloy composition is a Ni-based superalloy composition or a Co-based superalloy composition.

The additively manufactured article as described in any of the preceding clauses, wherein the superalloy composition comprises a titanium content and an aluminum content such that $w_{Al} + w_{Ti} >= 4.0$ wt.%, where $w_{Al}$ corresponds to a weight percentage of aluminum in the superalloy composition and $w_{Ti}$ corresponds to a weight percentage of titanium in the superalloy composition.

The additively manufactured article as described in any of the preceding clauses, wherein the superalloy composition comprises less than or equal to 13.5 wt% chromium.

The additively manufactured article as described in any of the preceding clauses, wherein the additively manufactured article is manufactured using an electron beam melting process.

The additively manufactured article as described in any of the preceding clauses, further comprising an application temperature of greater than or equal to 800°C.

An additively manufactured turbine blade comprising: an airfoil connected to a shank; a superalloy composition; and a graded microstructure comprising: a gamma-prime phase, wherein the gamma-prime phase is greater than or equal to 35% by volume of the graded microstructure; a first section comprising first grains with a first average aspect ratio; and a second section comprising second grains with a second average aspect ratio, wherein the second average aspect ratio is different than the first average aspect ratio.

An additively manufactured turbine blade comprising: an airfoil connected to a shank; a superalloy composition;

and a graded microstructure comprising: a gamma-prime phase, wherein the gamma-prime phase is greater than or equal to 35% by volume of the graded microstructure; a first section comprising first grains with a first average aspect ratio; and a second section comprising second grains with a second average aspect ratio, wherein the second average aspect ratio is different than the first average aspect ratio, and wherein: the airfoil comprises the first section, wherein the first average aspect ratio is greater than or equal to 5; and the shank comprises the second section, wherein the second average aspect ratio is less than or equal to 5.

An additively manufactured turbine blade comprising: an airfoil connected to a shank; a superalloy composition; and a graded microstructure comprising: a gamma-prime phase, wherein the gamma-prime phase is greater than or equal to 35% by volume of the graded microstructure; a first section comprising first grains with a first average aspect ratio; and a second section comprising second grains with a second average aspect ratio, wherein the second average aspect ratio is different than the first average aspect ratio, further comprising a third section comprising third grains with a third average aspect ratio different from the first average aspect ratio and the second average aspect ratio, wherein: the airfoil comprises a core and an outer shell surrounding the core, wherein: the core comprises the first section, wherein the first average aspect ratio is greater than or equal to 5; and the outer shell comprises the third section, wherein the third average aspect ratio is less than or equal to 3; and the shank comprises the second section, wherein the second average aspect ratio is less than or equal to 5.

An additively manufactured turbine blade comprising: an airfoil connected to a shank; a superalloy composition; and a graded microstructure comprising: a gamma-prime phase, wherein the gamma-prime phase is greater than or equal to 35% by volume of the graded microstructure; a first section comprising first grains with a first average aspect ratio; and a second section comprising second grains with a second average aspect ratio, wherein the second average aspect ratio is different than the first average aspect ratio, and wherein: the airfoil comprises a core and an outer shell surrounding the core, wherein: the core comprises a single crystal; and the outer shell comprises the second section, wherein the second average aspect ratio is less than or equal to 3; and the shank comprises the first section, wherein the first average aspect ratio is less than or equal to 5.

An additively manufactured turbine blade comprising: an airfoil connected to a shank; a superalloy composition; and a graded microstructure comprising: a gamma-prime phase, wherein the gamma-prime phase is greater than or equal to 35% by volume of the graded microstructure; a first section comprising first grains with a first average aspect ratio; and a second section comprising second grains with a second average aspect ratio, wherein the second average aspect ratio is different than the first average aspect ratio, and wherein: the airfoil comprises an airfoil core and an airfoil shell surrounding the airfoil core; the shank comprises a shank core and a shank shell surrounding the shank core; the airfoil core and the shank core comprise the first section, wherein the first average aspect ratio is greater than or equal to 5; and the airfoil shell and the shank shell comprise the second section, wherein the second average aspect ratio is less than or equal to 5.

The additively manufactured turbine blade as described in any of the preceding clauses, wherein the turbine blade is additively manufactured using an electron beam melting process.

**Claims**

1. An additively manufactured article (200) comprising:

    a superalloy composition; and
    a graded microstructure comprising:

        a gamma-prime phase, wherein the gamma-prime phase is greater than or equal to 35% by volume of the graded microstructure;
        a first section (202) comprising first grains with a first average aspect ratio of greater than or equal to 5; and
        a second section (204) comprising second grains with a second average aspect ratio of less than 5.

2. The additively manufactured article (200) of claim 1, wherein the first section (202) comprises a core of the additively manufactured article (200) and the second section (204) comprises an outer shell of the additively manufactured article (200).

3. The additively manufactured article (200) of either one of claims 1-2, wherein the additively manufactured article (200) is manufactured using an electron beam melting process.

4. The additively manufactured article (200) of any one of claims 1-3, wherein the additively manufactured article (200) comprises a build direction height of greater than or equal to 20 mm.

5. The additively manufactured article (200) of any one of claims 1-4, wherein the superalloy composition is a Ni-based superalloy composition or a Co-based superalloy composition.

6. The additively manufactured article (200) of any one of claims 1-5, wherein the superalloy composition comprises a titanium content and an aluminum content such that $w_{Al} + w_{Ti} >= 4.0$ wt.%, where $w_{Al}$ corresponds to a weight percentage of aluminum in the superalloy composition and $w_{Ti}$ corresponds to a weight percentage of titanium in the superalloy composition.

7. The additively manufactured article (200) of any one of claims 1-6, wherein the superalloy composition comprises less than or equal to 13.5 wt% chromium.

8. An additively manufactured turbine blade comprising:

   an airfoil connected to a shank;
   a superalloy composition; and
   a graded microstructure comprising:

   a gamma-prime phase, wherein the gamma-prime phase is greater than or equal to 35% by volume of the graded microstructure;
   a first section comprising first grains with a first average aspect ratio; and
   a second section comprising second grains with a second average aspect ratio, wherein the second average aspect ratio is different than the first average aspect ratio.

9. The additively manufactured turbine blade (310) of claim 8, wherein:

   the airfoil (312) comprises the first section (316), wherein the first average aspect ratio is greater than or equal to 5; and
   the shank (314) comprises the second section (318), wherein the second average aspect ratio is less than or equal to 5.

10. The additively manufactured turbine blade (410) of claim 8, further comprising a third section (420) comprising third grains with a third average aspect ratio different from the first average aspect ratio and the second average aspect ratio, wherein:
    the airfoil (412) comprises a core (422) and an outer shell (424) surrounding the core (422), wherein:

    the core (422) comprises the first section (416), wherein the first average aspect ratio is greater than or equal to 5; and
    the outer shell (424) comprises the third section (420), wherein the third average aspect ratio is less than or equal to 3; and the shank (414) comprises the second section (418), wherein the second average aspect ratio is less than or equal to 5.

11. The additively manufactured turbine blade (510) of claim 8, wherein:

    the airfoil (512) comprises a core (522) and an outer shell (524) surrounding the core (522), wherein:

    the core (522) comprises a single crystal; and
    the outer shell (524) comprises the second section (518), wherein the second average aspect ratio is less than or equal to 3; and

    the shank (514) comprises the first section (516), wherein the first average aspect ratio is less than or equal to 5.

12. The additively manufactured turbine blade (610) of claim 8, wherein:

    the airfoil (612) comprises an airfoil core (622) and an airfoil shell (624) surrounding the airfoil core (622);
    the shank (614) comprises a shank core (632) and a shank shell (634) surrounding the shank core (632);
    the airfoil core (622) and the shank core (632) comprise the first section (616), wherein the first average aspect ratio is greater than or equal to 5; and
    the airfoil shell (624) and the shank shell (634) comprise the second section (618), wherein the second average aspect ratio is less than or equal to 5.

13. The additively manufactured turbine blade of any one of claims 8-12, wherein the turbine blade is additively manufactured using an electron beam melting process.

FIG. 1

FIG. 2

FIG. 3

200

204

202

FIG. 4

200

204

202

FIG. 5

FIG. 6

FIG. 7

FIG. 8

FIG. 9

FIG. 10

FIG. 11

EP 4 559 598 A1

Tailored Microstructure

Columnar Grains

Equiaxed Grains

5 mm

build direction

FIG. 12

710

712

714

build direction

5 mm

FIG. 13

FIG. 14

FIG. 15

EP 4 559 598 A1

FIG. 16

Europäisches
Patentamt

European
Patent Office

Office européen
des brevets

# EUROPEAN SEARCH REPORT

**Application Number**

EP 24 20 8584

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Ramsperger Markus ET AL: "Selective Electron Beam Melting of the Single Crystalline Nickel-Base Superalloy CMSX-4 : From Columnar Grains to a Single Crystal : Proceedings of the 13th Intenational Symposium of Superalloys" In: "Superalloys 2016 : Proceedings of the 13th Intenational Symposium of Superalloys", 31 August 2016 (2016-08-31), John Wiley & Sons, Inc., Hoboken, NJ, USA, XP055964990, ISBN: 978-1-118-99666-9 pages 341-349, DOI: 10.1002/9781119075646.ch37, Retrieved from the Internet: URL:http://api.wiley.com/onlinelibrary/tdm /v1/articles/10.1002%2F9781119075646.ch37> | 1-7 | INV. B22F5/04 B22F7/06 B22F10/28 B22F10/364 B22F10/366 B22F10/368 B22F10/38 B33Y10/00 B33Y70/00 B33Y80/00 C22C1/04 C22C19/05 C30B29/52 B22F5/00 F01D5/14 F01D5/28 F23R3/00 |
| Y | * abstract; figures 1,6 *<br>* page 342 * | 13 | |
| T | US 2015/108098 A1 (ARJAKINE NIKOLAI [DE] ET AL) 23 April 2015 (2015-04-23)<br>* figure 2 * | 6,7 | **TECHNICAL FIELDS SEARCHED (IPC)**<br><br>B22F<br>F23R |
| X | EP 3 839 213 A1 (GEN ELECTRIC [US]) 23 June 2021 (2021-06-23) | 1,4-12 | C22C<br>F01D |
| Y | * paragraphs [0001], [0015] - [0017], [0022], [0025], [0028] - [0029]; claims 1,4,6,7,9; figures 1-5,7 * | 13 | C30B<br>B33Y<br>C22F |
| X | US 2023/018317 A1 (BELAYGUE PHILIPPE GABRIEL LOUIS [FR] ET AL) 19 January 2023 (2023-01-19)<br>* paragraphs [0048], [0054], [0056] - [0058]; claim 14; figures 1-2 * | 1,4-9 | |

-/--

The present search report has been drawn up for all claims

| Place of search | Date of completion of the search | Examiner |
|---|---|---|
| The Hague | 14 April 2025 | Aliouane, Nadir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 24 20 8584

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2014/131444 A1 (SLM SOLUTIONS GMBH [DE]) 4 September 2014 (2014-09-04)<br>* page 2, lines 26-34 *<br>* page 7, line 34 - page 8, line 5 *<br>* page 12, lines 16-24; claims 14,15; table 1 * | 1-13 | C30B28/06<br>C30B11/00<br><br>ADD.<br>C22F1/10<br>B22F3/15 |
| A | WO 2022/258475 A1 (UNIV FRIEDRICH ALEXANDER ER [DE]) 15 December 2022 (2022-12-15)<br>* page 26, lines 15-24; claims 1,10,18,20; figures 1-5 *<br>* page 30, line 14 - page 32, line 7 * | 1-13 | |
| A | CN 111 187 895 B (UNIV NANCHANG HANGKONG) 10 August 2021 (2021-08-10)<br>* claims 1-7; figures 2-3; example 1 * | 9 | |

TECHNICAL FIELDS
SEARCHED (IPC)

The present search report has been drawn up for all claims

| Place of search | Date of completion of the search | Examiner |
|---|---|---|
| The Hague | 14 April 2025 | Aliouane, Nadir |

## ANNEX TO THE EUROPEAN SEARCH REPORT
## ON EUROPEAN PATENT APPLICATION NO.

EP 24 20 8584

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2025

| Patent document cited in search report | | Publication date | Patent family member(s) | | Publication date |
|---|---|---|---|---|---|
| US 2015108098 | A1 | 23-04-2015 | CN | 104551405 A | 29-04-2015 |
| | | | EP | 2862663 A1 | 22-04-2015 |
| | | | US | 2015108098 A1 | 23-04-2015 |
| EP 3839213 | A1 | 23-06-2021 | CN | 112981183 A | 18-06-2021 |
| | | | EP | 3839213 A1 | 23-06-2021 |
| | | | JP | 2021095636 A | 24-06-2021 |
| | | | US | 2021189539 A1 | 24-06-2021 |
| US 2023018317 | A1 | 19-01-2023 | CN | 115135431 A | 30-09-2022 |
| | | | EP | 4081360 A1 | 02-11-2022 |
| | | | FR | 3105035 A1 | 25-06-2021 |
| | | | US | 2023018317 A1 | 19-01-2023 |
| | | | WO | 2021130433 A1 | 01-07-2021 |
| WO 2014131444 | A1 | 04-09-2014 | CN | 105026076 A | 04-11-2015 |
| | | | EP | 2961549 A1 | 06-01-2016 |
| | | | JP | 6200969 B2 | 20-09-2017 |
| | | | JP | 2016516888 A | 09-06-2016 |
| | | | US | 2016008922 A1 | 14-01-2016 |
| | | | WO | 2014131444 A1 | 04-09-2014 |
| WO 2022258475 | A1 | 15-12-2022 | DE | 102021114560 A1 | 08-12-2022 |
| | | | EP | 4351821 A1 | 17-04-2024 |
| | | | US | 2024263339 A1 | 08-08-2024 |
| | | | WO | 2022258475 A1 | 15-12-2022 |
| CN 111187895 | B | 10-08-2021 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 22819823

- US 228198

**Non-patent literature cited in the description**

- **SEHER et al.** Quantitative Metallography of the Age Hardening Precipitate in Superalloys by Replica Electron Microscopy. *Symposium on Stereology and Quantitative Metallography*, 1972, 119-137